# EUROPEAN PATENT APPLICATION

(11) **EP 2 405 725 A1**
(43) Date of publication of application: **11.01.2012**
(21) Application number: 10741209.0
(22) Date of filing: 08.02.2010
(51) Int. Cl.: H05K 3/18, H05K 3/00, H05K 3/10, H05K 3/26

(54) **RESIN COMPOSITION FOR WIRING BOARD, RESIN SHEET FOR WIRING BOARD, COMPOSITE BODY, METHOD FOR PRODUCING COMPOSITE BODY, AND SEMICONDUCTOR DEVICE**

(30) Priority: 12.02.2009 JP 2009029360; 31.03.2009 JP 2009087151; 02.04.2009 JP 2009089710
(71) Applicant: Sumitomo Bakelite Company Limited, Shinagawa-ku Tokyo 140-0002 (JP)
(72) Inventor: ITO,Yuka, Tokyo 140-0002 (JP); KANEDA, Kenichi, Tokyo 140-0002 (JP); MITSUI, Yasuaki, Tokyo 140-0002 (JP); ONOZUKA, Iji, Tokyo 140-0002 (JP); OHIGASHI, Noriyuki, Tokyo 140-0002 (JP); HARA, Hideki, Tokyo 140-0002 (JP)
(74) Representative: Vossius, Corinna
(86) International application number: PCT/JP2010/051821
(87) International publication number: WO 2010/092932

(57) **Abstract**

Disclosed are a composite body, a method for producing the composite body and a semiconductor device, the composite body comprising a resin layer and a fine wiring and/or via hole being formed in the resin layer, having high adhesion and high reliability, and being capable of high frequencies. Also disclosed are a resin composition and a resin sheet, both of which can provide such a composite body.

The composite body comprises a resin layer and an electroconductive layer, wherein a groove having a maximum width of 1 µm or more and 10 µm or less is on a surface of the resin layer; the electroconductive layer is inside the groove; and a surface of the resin layer being in contact with the electroconductive layer has an arithmetic average roughness (Ra) of 0.05 µm or more and 0.45 µm or less, and/or wherein the resin layer has a via hole having a diameter of 1 µm or more and 25 µm or less; the electroconductive layer is inside the via hole; and a surface of the resin layer of the inside of the via hole has an arithmetic average roughness (Ra) of 0.05 µm or more and 0.45 µm or less. The resin composition comprises an inorganic filler and a thermosetting resin, wherein the inorganic filler contains coarse particles having a diameter of more than 2 µm in an amount of 500 ppm or less. The resin sheet comprises a resin layer and a substrate, wherein the resin layer is on the substrate and comprises the resin composition.

## Description

### Technical Field

The present invention relates to a resin composition for wiring board, a resin sheet for wiring board, a composite body used for wiring, a method for producing the composite body, and a semiconductor device.

### Background Art

In recent years, with growing demand for higher functionalization, weight reduction, miniaturization and decrease in layer thickness of electronics, there has been development in high density integration and high density mounting of electronic components. There is a tendency that circuit wirings are densely formed on printed wiring boards used for the electronics; therefore, build-up multilayer wiring structures have been employed.

As a method for forming a circuit wiring pattern, generally, there is a method for etching a copper foil (subtractive method). The thickness of a circuit formed by the subtractive method is characterized by being defined by the thickness of the used copper foil, and circuit width accuracy depends on the reaction properties of an etching solution and the performance of an etching device used therefor. Therefore, the subtractive method is generally unsuitable for increasing density, except for some applications which uses an ultrathin metal foil.

On the other hand, an example of the method generally applicable to the production of a build-up substrate and a multilayer wiring board is a semi-additive method. The method comprises the following steps: first, a resin surface is roughened by desmear treatment; an electroless copper plating layer is formed on the roughened surface using a palladium catalyst; a photosensitive resist is further formed on the copper plating layer; patterning is performed thereon through processes such as exposure and development; a circuit pattern is formed by electrolytic copper plating; finally, the resist is peeled and then the electroless copper plating layer is removed by flash etching, thereby forming a fine wiring (for example, see Patent Literature 1). However, in the case of forming a fine wiring by this method, there is a problem with resist exposure/development accuracy, or there is a problem of unusual plating precipitation due to a palladium catalyst residue left between wirings. Therefore, it is difficult to form a fine wiring having circuit width/circuit distance (L/S) of 10 µm/10 µm or less.

By the subtractive method and semi-additive method, a convex wiring is formed on the surface of the resin layer. In the build-up substrate or multilayer wiring board, subsequent steps include a step of stacking resin layers; however, depending on the resin composition, there could be caused a problem with embedding properties of the resin. Particularly in the region of a fine wiring having circuit width/circuit distance (L/S) of 10 µm/10 µm or less, it is difficult to obtain insulation reliability when the resin has poor embedding properties.

There is also a method comprising the following steps: first, a groove is formed on a resin layer with scribe, plasma, laser or the like; the surface of the resin layer is roughened by desmear treatment; an electroless copper plating layer is formed on the roughened surface using a palladium catalyst, followed by forming an electric conductor by electrolytic copper plating; finally, the electric conductor plating is removed by etching, except the plating in the groove, thereby forming a circuit (for example, see Patent Literatures 2 and 3).

An example of the method for connecting circuit wiring layers through a resin layer is a method for forming a via hole in the resin layer to connect the layers (for example, see Patent Literature 4). The via hole is formed by exposing the resin layer to laser such as carbon dioxide laser, YAG laser or excimer laser to form an opening; thereafter, circuit wiring layers are connected by filling an electroconductive resin or plating.

### Citation List

### [Patent Literature]

[Patent Literature 1] Japanese Patent Application Laid-Open (JP-A) No. H8-64930
[Patent Literature 2] JP-A No. H10-4253
[Patent Literature 3] JP-A No. 2006-41029
[Patent Literature 4] JP-A No. 2008-274210

### Summary of Invention

### Technical Problem

The method for forming a circuit by forming a groove on a resin layer with scribe, plasma, laser or the like has a problem with accuracy upon forming the groove since the surface roughness of the side wall surface of the groove on the resin layer is increased, so that it is difficult to form a fine wiring having circuit width/circuit distance (L/S) of 10 µm/10 µm or less. Also, in the case of forming a via hole with laser, there is a problem with accuracy upon forming the via hole since the surface roughness of the resin surface of the inside of the via hole is increased due to the influence of an inorganic filler in the resin layer or the laser wavelength absorption properties of the resin, so that it is difficult to form a via hole having a diameter of 20 µm or less.
The present invention has been made in view of the above circumstances, and it is an object of the present invention to provide: a composite body comprising a resin layer and a fine wiring which is formed on a surface of the resin layer of the composite body, has high adhesion and high reliability, and is capable of high frequencies; a composite body comprising a resin layer and a via hole which is formed in the resin layer of the composite body, has high density and high reliability, and is capable of high frequencies; methods for producing the composites; and a semiconductor device comprising the composite(s).
Also, the present invention provides a resin composition and a resin sheet. When used for the insulating layer of a wiring board, they are excellent in groove formability for forming a fine wiring having circuit width/circuit distance (L/S) of 10 µm/10 µm or less and fine via hole formability by laser processing; moreover, they form an insulating layer having high adhesion to the thus-formed electroconductive layer.

### Solution to Problem

The above objects can be achieved by the following [1] to [25].
[1] A composite body comprising a resin layer and an electroconductive layer, wherein a groove having a maximum width of 1 µm or more and 10 µm or less is on a surface of the resin layer; the electroconductive layer is inside the groove; and a surface of the resin layer being in contact with the electroconductive layer has an arithmetic average roughness (Ra) of 0.05 µm or more and 0.45 µm or less.
[2] A composite body comprising a resin layer and an electroconductive layer, wherein the resin layer has a via hole having a diameter of 1 µm or more and 25 µm or less; the electroconductive layer is inside the via hole; and a surface of the resin layer of the inside of the via hole has an arithmetic average roughness (Ra) of 0.05 µm or more and 0.45 µm or less.
[3] The composite body according to [2], wherein a groove having a maximum width of 1 µm or more and 10 µm or less is further on the surface of the resin layer; the electroconductive layer is further inside the groove; and a surface of the resin layer being in contact with the electroconductive layer has an arithmetic average roughness (Ra) of 0.05 µm or more and 0.45 µm or less.
[4] The composite body according to any of [1] to [3], wherein the resin layer comprises an inorganic filler, and the inorganic filler contains coarse particles having a diameter of more than 2 µm in an amount of 500 ppm or less.
[5] The composite body according to [4], wherein the inorganic filler has an average particle diameter of 0.05 µm or more and 1.0 µm or less.
[6] The composite body according to any of [1] to [5], wherein a cross-sectional shape of the electroconductive layer inside the groove is an approximate trapezoidal shape, a semicircular shape or a triangular shape.
[7] The composite body according to any of [2] to [6], wherein a cross-sectional shape of the via hole is an approximate trapezoidal shape.
[8] The composite body according to any of [1] to [7], wherein the composite body is at least one selected from a printed wiring board, a semiconductor element and a metal core wiring board.

[9] A method for producing a composite body comprising a resin layer and an electroconductive layer, comprising: (A) a step of forming a groove having an inner surface with an arithmetic average roughness (Ra) of 0.05 µm or more and 0.45 µm or less on a surface of the resin layer with laser beam, (B) a step of forming an electric conductor on the surface of the resin layer by electroless plating, and (C) a step of forming an electroconductive layer only in the groove on the resin layer by removing part of the electric conductor.
[10] The method for producing the composite body according to [9], wherein the method comprises, after the step (C), (D) a step of forming a different resin layer on the resin layer and the electroconductive layer.
[11] A method for producing a composite body comprising a resin layer and an electroconductive layer, comprising: (A) a step of forming a via hole having an inner surface with an arithmetic average roughness (Ra) of 0.05 µm or more and 0.45 µm or less in the resin layer with laser beam, (B) a step of forming an electric conductor on a surface of the resin layer by electroless plating, and (C) a step of forming an electroconductive layer only in the via hole of the resin layer by removing part of the electric conductor.
[12] The method for producing the composite body according to [11], wherein the step (A) is a step of forming the via hole having the inner surface with an arithmetic average roughness (Ra) of 0.05 µm or more and 0.45 µm or less in the resin layer with laser beam, and a groove having an inner surface with an arithmetic average roughness (Ra) of 0.05 µm or more and 0.45 µm or less on a surface of the resin layer with laser beam, and the step (C) is a step of forming the electroconductive layer only in the via hole of the resin layer and the groove on the surface of the resin layer by removing part of the electric conductor.
[13] The method for producing the composite body according to [11] or [12], wherein the method comprises, after the step (C), (D) a step of forming a different resin layer on the resin layer and the electroconductive layer.
[14] The method for producing the composite body according to any of [9] to [13], wherein the method comprises a step of performing desmear with plasma or chemical solution between the steps (A) and (B).
[15] The method for producing the composite body according to any of [9] to [14], wherein the method comprises a step of further forming an electric conductor by electrolytic plating between the steps (B) and (C).
[16] The method for producing the composite body according to any of [9] to [15], wherein the laser beam is excimer laser or YAG laser.
[17] The method for producing the composite body according to any of [9] to [16], wherein, in the step (A), the resin layer comprises an inorganic filler, and the inorganic filler contains coarse particles having a diameter of more than 2 µm in an amount of 500 ppm or less.
[18] The method for producing the composite body according to [17], wherein the inorganic filler has an average particle diameter of 0.05 µm or more and 1.0 µm or less.
[19] The method for producing the composite body according to any of [9] to [18], wherein the composite body is at least one selected from a printed wiring board, a semiconductor element and a metal core wiring board.
[20] A semiconductor device comprising the composite body defined by any of [1] to [8] and a semiconductor element mounted thereon, wherein the composite body is a printed wiring board or metal core wiring board.

[21] A resin composition for wiring board, comprising an inorganic filler and a thermosetting resin, wherein the inorganic filler contains coarse particles having a diameter of more than 2 µm in an amount of 500 ppm or less.
[22] The resin composition for wiring board according to [21], wherein the inorganic filler has an average particle diameter of 0.05 µm or more and 1.0 µm or less.
[23] The resin composition for wiring board according to [21] or [22], wherein a content of the inorganic filler is 10 to 80% by weight of the resin composition.
[24] The resin composition for wiring board according to any of [21] to [23], wherein the inorganic filler is spherical silica.
[25] A resin sheet for wiring board, comprising a resin layer and a substrate, wherein the resin layer is on the substrate and comprises the resin composition defined by any of [21] to [24].

### Advantageous Effects of Invention

The present invention provides: a composite body comprising a resin layer and a fine wiring which is formed on a surface of the resin layer of the composite body, has high adhesion and high reliability, and is capable of high frequencies; a composite body comprising a resin layer and a via hole which is formed in the resin layer of the composite body, has high density and high reliability, and is capable of high frequencies; and a semiconductor device comprising the composite body.
Also, when used for the insulating layer of a wiring board, a resin composition of the present invention and a resin sheet comprising the same can form a fine wiring having circuit width/ circuit distance (L/S) of 10 µm/ 10 µm or less and a fine via hole by laser processing, and the thus-formed insulating layer and electroconductive layer have high adhesion to each other.

### Brief Description of Drawings

FIG. 1 is a schematic sectional view showing an example of a composite body of the present invention, comprising a resin layer and an electroconductive layer.
FIG. 2 is a schematic sectional view showing an example of a different composite body of the present invention, comprising a resin layer and an electroconductive layer.
FIG. 3 is a schematic sectional view showing an example of a different composite body of the present invention, comprising a resin layer and an electroconductive layer.
FIG. 4 shows a resin sheet of the present invention.
FIGS. 5A to 5F are schematic views showing an example of a method for producing the composite body of the present invention, comprising the resin layer and the electroconductive layer.
FIGS. 6A to 6F are schematic view showing an example of a different method for producing the composite body of the present invention, comprising the resin layer and the electroconductive layer.
FIG. 7 is a photograph showing a cross-sectional shape of the composite body at the stage where a groove is formed on an insulating layer with laser and an electric conductor is formed by electroless plating/electrolytic plating in Example I-1.
FIG. 8 is a photograph showing a cross-sectional shape of the composite body at the stage where a groove is formed on an insulating layer with laser and an electric conductor is formed by electroless plating/electrolytic plating in Comparative example I-1.

### Description of Embodiments

A first composite body of the present invention is a composite body comprising a resin layer and an electroconductive layer, wherein a groove having a maximum width of 1 µm or more and 10 µm or less is on a surface of the resin layer; the electroconductive layer is inside the groove; and a surface of the resin layer being in contact with the electroconductive layer has an arithmetic average roughness (Ra) of 0.05 µm or more and 0.45 µm or less.
A second composite body of the present invention is a composite body comprising a resin layer and an electroconductive layer, wherein the resin layer has a via hole having a diameter of 1 µm or more and 25 µm or less; the electroconductive layer is inside the via hole; and a surface of the resin layer of the inside of the via hole has an arithmetic average roughness (Ra) of 0.05 µm or more and 0.45 µm or less.
A method for producing the composite body of the present invention is a method for producing a composite body comprising a resin layer and an electroconductive layer, comprising: (A) a step of forming a groove having an inner surface with an arithmetic average roughness (Ra) of 0.05 µm or more and 0.45 µm or less on a surface of the resin layer with laser beam and/or a via hole having an inner surface with an arithmetic average roughness (Ra) of 0.05 µm or more and 0.45 µm or less in the resin layer with laser beam, (B) a step of forming an electric conductor on the surface of the resin layer by electroless plating, and (C) a step of forming an electroconductive layer only in the groove on the surface of the resin layer and/or the via hole of the resin layer by removing part of the electric conductor.

The present invention focuses attention on surface roughness of a part of the resin layer being in contact with the electroconductive layer and specifies the surface roughness of the resin layer to be a specific value. Thus, it is possible to decrease surface roughness of the electroconductive layer, while obtaining adhesion between the electroconductive layer and resin layer in a fine wiring and via hole; moreover, it is possible to decrease transmission loss due to the skin effect in the high-frequency region of over 1 GHz. Thereby, it is possible to obtain a composite body comprising a resin layer and a fine wiring which is formed on the surface of the resin layer of the composite body, has high adhesion and high reliability, and is capable of high frequencies, and/or a via hole which is formed in the resin layer of the composite body, has high density and high reliability, and is capable of high frequencies. Hereinafter, the composite body of the present invention, the method for producing the same, a semiconductor device, a resin composition and resin sheet for wiring board, will be described in detail.

First, the composite body of the present invention will be described. The composite body of the present invention comprises the resin layer and the electroconductive layer, and is suitably used as a wiring board, etc. Examples of the composite body include a printed wiring board comprising a resin layer and electroconductive layer formed on a substrate, a build-up multilayer printed wiring board comprising a resin layer (for example, a build-up layer) and electroconductive layer formed on a printed wiring board, a metal core wiring board comprising a resin layer and electroconductive layer formed on a metal substrate, and a re-distribution layer of a semiconductor element comprising a resin layer and electroconductive layer formed on a wafer.

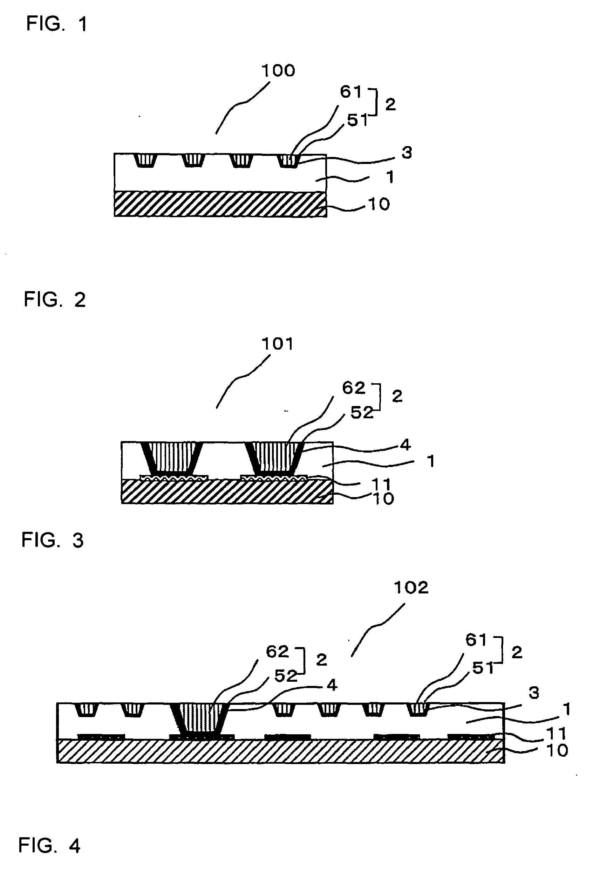

FIG. 1 shows an example of the first composite body of the present invention. First composite body 100 of the present invention can comprise substrate 10 and is a composite body comprising resin layer 1 and electroconductive layer 2, wherein groove 3 having a maximum width of 1 µm or more and 10 µm or less is on the surface of resin layer 1; electroconductive layer 2 is inside the groove; and the surface of the resin layer being in contact with electroconductive layer 2 has an arithmetic average roughness (Ra) of 0.05 µm or more and 0.45 µm or less. As shown by 51 and 61 in FIG. 1, electroconductive layer 2 can comprise two or more kinds of electroconductive layers. The width of the groove means an upper side length of a cross-section of the groove in a direction that is perpendicular to a longitudinal direction of the groove.

In general, the maximum width of the electroconductive layer inside the groove on the surface of the resin layer, is the same as that of the groove. In the embodiment of the first composite body of the present invention, the groove on the surface of the resin layer and the electroconductive layer have a maximum width of 1 µm or more and 10 µm or less. Thereby, the composite body can obtain high density, high mounting and a fine wiring. The maximum width of the groove on the surface of the resin layer and the electroconductive layer is not particularly limited and is preferably 8 µm or less, more preferably 6 µm or less, still more preferably 4 µm or less. Thereby, the composite body can effectively exert the effects of high density and high mounting.
The groove on the surface of the resin layer preferably has a depth of 1 µm or more and 20 µm or less.

In the present invention, the surface of the resin layer of the inside of the groove, which is in contact with electroconductive layer 2 has an arithmetic average roughness (Ra) of 0.05 µm or more and 0.45 µm or less. The arithmetic average roughness (Ra) of the surface of the resin layer inside the groove, which is in contact with the electroconductive layer is reflected on that of the surface of the electroconductive layer inside the groove. As a result of optimizing the surface roughness of the inside of the groove on the resin layer, it is possible to decrease the surface roughness of the electroconductive layer, while obtaining adhesion between the resin layer and the electroconductive layer, and it is also possible to decrease transmission loss due to the skin effect in the high-frequency region of over 1 GHz. Thereby, it is possible to obtain a fine wiring which is capable of high frequencies. High-frequency signals are transmitted through the surface of a conductor circuit. However, if the surface roughness of the electroconductive layer is too large, there is an increase in transmission distance, resulting in slow transmission and large transmission loss. The arithmetic average roughness (Ra) is not particularly limited and is preferably 0.05 µm or more and 0.30 µm or less, more preferably 0.1 µm or more and 0.25 µm or less. Thereby, the composite body can efficiently exert the effect of decreasing transmission loss in the high-frequency region.

If the arithmetic average roughness (Ra) is less than the lower limit, the electroconductive layer could be peeled off in the solder heat resistance test, hot-cold cycle test, etc. If the arithmetic average roughness (Ra) exceeds the upper limit, there could be trouble in high-speed signal transmission and thus in electrical reliability.

In the present invention, the arithmetic average roughness (Ra) is that defined by JIS B0601. The arithmetic average roughness (Ra) of the surface of the groove formed on the resin layer can be measured according to JIS B0601 by means of WYKO NT1100 (product name; manufactured by: Veeco Instruments Inc.), for example.

In the present invention, the surface of the resin layer inside the groove, which is in contact with electroconductive layer 2 preferably has a ten point average roughness (Rz) of 6.0 µm or less, more preferably 4.0 µm or less. The ten point average roughness (Rz) of the surface of the resin layer inside the groove, which is in contact with the electroconductive layer is reflected on that of the surface of the electroconductive layer inside the groove. The ten point average roughness (Rz) is a sum of an average of 5 points obtained from the maximum height and an average of 5 points obtained from the maximum depth in a measured length, so that it is possible to evaluate the maximum convex of the surface of the electroconductive layer inside the groove. If the ten point average roughness (Rz) is too large, due to the maximum convex of the electroconductive layer, there could be an area where the distance between fine wirings is significantly short, which could be disadvantageous to insulation and result in a decrease in reliability. The ten point average roughness (Rz) is more preferably 4.0 µm or less. Thereby, the fine wirings can effectively exert reliability.

In the present invention, the ten point average roughness (Rz) is that defined by JIS B0601. The ten point average roughness (Rz) of the surface of the groove formed on the resin layer can be measured accirding to JIS B0601 by means of WYKO NT1100 (product name; manufactured by: Veeco Instruments Inc.), for example.

A cross-sectional shape of the groove on the surface of the resin layer of the composite body of the present invention and a cross-sectional shape of the electroconductive layer inside the groove are preferably an approximate trapezoidal shape, a semicircular shape or a triangular shape. Thereby, it is possible to form a fine wiring with excellent signal response.

The electroconductive layer inside the groove is not particularly limited as long as it is an electric conductor, and is preferably formed by plating. The electroconductive layer preferably contains, for example, metal such as copper or nickel.

FIG. 2 shows an example of the second composite body of the present invention. Second composite body 101 of the present invention can comprise substrate 10 with electroconductive layer 11, and it is a composite body comprising resin layer 1 and electroconductive layer 2, wherein resin layer 1 has via hole 4 having a diameter of 1 µm or more and 25 µm or less; electroconductive layer 2 is inside the via hole; and the surface of the resin layer of the inside of the via hole has an arithmetic average roughness (Ra) of 0.05 µm or more and 0.45 µm or less. As shown by 52 and 62 in FIG. 2, electroconductive layer 2 can comprise two or more kinds of electroconductive layers.

In the embodiment of the second composite body of the present invention, the via hole has a diameter of 1 µm or more and 25 µm or less. Thereby, the composite body can obtain high density, high mounting and a fine wiring. The diameter of the via hole is not particularly limited and is preferably 20 µm or less, more preferably 18 µm or less, still more preferably 15 µm or less. Thereby, the composite body can effectively exert the effects of high density, high mounting and fine wiring.

If the diameter of the via hole is less than the lower limit, there could be an area in the resin layer, where no via hole can be formed with laser beam, or a connection failure, or circulation of plating solution could be poor and the poor circulation results in a failure to form an electric conductor by plating, so that circuit wiring layers could not be connected. Also, in the solder heat resistance test, hot-cold cycle test, etc., peeling could occur at the interface between the electroconductive layer and the resin of the inside of the via hole. If the diameter of the via hole exceeds the upper limit, when forming the via hole with laser beam, the via hole could be misshapen or the resin could have a crack, or there could be a decrease in insulation reliability between the via holes due to application of excessive heat to the resin. In addition, it is difficult for the composite body to obtain high density, high mounting and fine wiring.

In the embodiment of the second composite body of the present invention, the surface of the resin layer of the inside of the via hole, which is in contact with electroconductive layer 2 has an arithmetic average roughness (Ra) of 0.05 µm or more and 0.45 µm or less. As a result of optimizing the surface roughness of the inside of the via hole in the resin layer, it is possible to decrease the surface roughness of the resin layer of the inside of the via hole, while obtaining adhesion between the resin layer and the electroconductive layer, and it is also possible to decrease transmission loss due to the skin effect in the high-frequency region of over 1 GHz, and to reduce plating failure inside the via hole and connection failure between the layers. The arithmetic average roughness (Ra) is not particularly limited and is preferably 0.05 µm or more and 0.30 µm or less, more preferably 0.1 µm or more and 0.25 µm or less.
Thereby, the composite body can effectively exert the effects of decreasing transmission loss in the high-frequency region, plating failure inside the via hole, and connection failure between the layers.

If the arithmetic average roughness (Ra) of the surface of the resin of the inside of the via hole is less than the lower limit, in the solder heat resistance test, hot-cold cycle test, etc., peeling could occur at the interface between the electric conductor inside the via hole and the resin. If the arithmetic average roughness (Ra) exceeds the upper limit, there could be trouble in high-speed signal transmission and thus in electrical reliability. Moreover, there could be plating failure inside the via hole and connection failure between the layers.

A cross-sectional shape of the via hole of the composite body of the present invention is preferably an approximate trapezoidal shape. Thereby, it is possible to form a via hole with excellent signal response, connection reliability and plating adhesion.
The electroconductive layer inside the via hole is not particularly limited as long as it is an electric conductor, and is preferably formed by plating. The electroconductive layer preferably contains, for example, metal such as copper or nickel.

Even in the second composite body of the present invention, the electroconductive layer present on the surface of the resin layer preferably has a maximum width of 1 µm or more and 10 µm or less. Thereby, the composite body can obtain high density and high mounting. The maximum width of the electroconductive layer is not particularly limited and is preferably 8 µm or less, more preferably 6 µm or less, still more preferably 4 µm or less. Thereby, the composite body can effectively exert the effects of high density and high mounting.

Even in the second composite body of the present invention, it is preferable that a groove having a maximum width of 1 µm or more and 10 µm or less is further on the surface of the resin layer; the electroconductive layer is further inside the groove; and a surface of the resin layer being in contact with the electroconductive layer has an arithmetic average roughness (Ra) of 0.05 µm or more and 0.45 µm or less. An example of such a composite body is shown in FIG. 3. Second composite body 102 of the present invention can comprise substrate 10 with electroconductive layer 11, and it is a composite body comprising resin layer 1 and electroconductive layer 2, wherein resin layer 1 has via hole 4 having a diameter of 1 µm or more and 25 µm or less; electroconductive layer 2 is inside the via hole; and the surface of the resin layer of the inside of the via hole has an arithmetic average roughness (Ra) of 0.05 µm or more and 0.45 µm or less. Moreover, groove 3 having a maximum width of 1 µm or more and 10 µm or less is further on the surface of resin layer 1; electroconductive layer 2 is further inside the groove; and the surface of the resin layer being in contact with electroconductive layer 2 has an arithmetic average roughness (Ra) of 0.05 µm or more and 0.45 µm or less.
When the second composite body comprises such a groove on the surface of the resin layer and such an electroconductive layer inside the groove, they can be the same as those described above in connection with the first composite body.

A thickness of the resin layer is not particularly limited and is preferably 1 µm or more and 60 µm or less, more preferably 5 µm or more and 40 µm or less. The thickness of the resin layer is preferably the lower limit or more from the viewpoint of increasing insulation reliability, and it is preferably the upper limit or less from the viewpoint of decreasing the thickness of a multilayer printed wiring board. Thereby, in the production of a printed wiring board, it is possible to form an insulating layer in which convexoconcaves of the electroconductive layer of the inner layer circuit board are filled, and to provide a suitable thickness to the insulating layer.

Next, the resin composition used for the resin layer will be described. The resin composition for forming the resin layer preferably contains a thermosetting resin. In particular, in the composite body of the present invention, the resin layer having the groove and/or via hole is preferably made of a cured product of the resin composition containing the thermosetting resin. By containing the cured product of the thermosetting resin, heat resistance of the resin layer can be increased.

Examples of the thermosetting resin include: novolac type phenol resins such as phenol novolac resins, cresol novolac resins and bisphenol A novolac resins; resol type phenol resins such as unmodified resol type phenol resins and oil-modified type resol phenol resins modified by wood oil, linseed oil, walnut oil or the like; phenol resins such as biphenyl aralkyl type phenol resins; bisphenol type epoxy resins such as bisphenol A type epoxy resins, bisphenol F type epoxy resins, bisphenol E type epoxy resins, bisphenol S type epoxy resins, bisphenol Z type epoxy resins, bisphenol P type epoxy resins and bisphenol M type epoxy resins; novolac type epoxy resins such as phenol novolac type epoxy resins and cresol novolac epoxy resins; epoxy resins such as biphenyl type epoxy resins, biphenyl aralkyl type epoxy resins, aryl alkylene type epoxy resins, naphthalene type epoxy resins, anthracene type epoxy resins, phenoxy type epoxy resins, dicyclopentadiene type epoxy resins, norbornene type epoxy resins, adamantane type epoxy resins and fluorene type epoxy resins; urea resins; resins having a triazine ring, such as melamine resins; unsaturated polyester resins; bismaleimide resins; polyimide resins; polyamide-imide resins; polyurethane resins; diallyl phthalate resins; silicone resins; resins having a benzoxazine ring; triazine resins; benzocyclobutene resins; and cyanate resins. Among them, the resin composition preferably contains one or more resins selected from epoxy resins, phenol resins, cyanate resins and benzocyclobutene resins, more preferably contains an epoxy resin and one or both of a phenol resin and a cyanate resin, and still more preferably contains a cyanate resin. Thereby, thermal expansion coefficient of the resin layer can be decreased. In addition, by containing a cyanate resin, the resin layer can obtain excellent electrical properties (such as low-dielectric constant and low-dielectric tangent), mechanical strength and laser processability. Particularly, it can obtain excellent excimer laser and YAG laser processibility.

Specific examples of the cyanate resins include novolac type cyanate resins; bisphenol type cyanate resins such as bisphenol A type cyanate resins, bisphenol E type cyanate resins and tetramethyl bisphenol F type cyanate resins; naphthol aralkyl type cyanate resins; biphenyl aralkyl type cyanate resins; and dicyclopentadiene type cyanate resins. Among them, novolac type cyanate resins are preferable. Novolac type cyanate resins can decrease the thermal expansion coefficient of the resin layer and provide excellent mechanical strength and electrical properties (such as low-dielectric constant and low-dielectric tangent) to the resin layer. Also, naphthol aralkyl type cyanate resins and biphenyl aralkyl type cyanate resins can be preferably used since they have excellent low linear expansion, low water absorption and mechanical strength.

The cyanate resin preferably has, but not particularly limited to, a weight average molecular weight of 500 to 4,500, more preferably 600 to 3,000. If the weight-average molecular weight is less than the lower limit, there could be a decrease in mechanical strength of the cured product constituting the resin layer, and the thus-produced resin layer could be tacky and the resin could be transferred. If the weight average molecular weight exceeds the upper limit, the rate of curing reaction is increased, and when producing a substrate (particularly a circuit substrate), there could be caused forming failure or a decrease in peel strength between the layers. The weight average molecular weight of the cyanate resin or the like can be measured by, for example, gel permeation chromatography (GPC; polystyrene calibrated standard substance).

The above cyanate resins (including derivatives thereof) can be used alone or in combination of two or more kinds having different weight average molecular weights. They can be used alone in combination with a prepolymer thereof, or two or more kinds of them and prepolymers thereof can be used in combination.
A content of the cyanate resin is not particularly limited and is preferably 5 to 50% by weight, more preferably 10 to 30% by weight, with respect to the total content of the resin composition. If the content is less than the lower limit, there could be a decrease in reactivity and low thermal expansion characteristics of the thermosetting resin composition, or a decrease in heat resistance of the thus-obtained product. If the content exceeds upper limit, there could be a decrease in humidity resistance.

When a cyanate resin (particularly a novolac type cyanate resin) is used as the thermosetting resin, it is preferable to use an epoxy resin (substantially containing no halogen atom) in combination.

Examples of the epoxy resin include: bisphenol type epoxy resins such as bisphenol A type epoxy resins, bisphenol F type epoxy resins, bisphenol E type epoxy resins, bisphenol S type epoxy resins, bisphenol Z type epoxy resins, bisphenol P type epoxy resins and bisphenol M type epoxy resins; novolac type epoxy resins such as phenol novolac type epoxy resins and cresol novolac type epoxy resins; biphenyl type epoxy resins; aryl alkylene type epoxy resins such as xylylene type epoxy resins and biphenyl aralkyl type epoxy resins; naphthalene type epoxy resins; naphthol aralkyl type epoxy resins; anthracene type epoxy resins; phenoxy type epoxy resins; dicyclopentadiene type epoxy resins; norbornene type epoxy resins; adamantane type epoxy resins; and fluorene type epoxy resins. These epoxy resins can be used alone or in combination of two or more kinds having different weight average molecular weights. They can be used alone in combination with a prepolymer thereof, or two or more kinds of them and prepolymers thereof can be used in combination.

Among the above epoxy resins, aryl alkylene type epoxy resins are particularly preferable. Thereby, hygroscopic solder heat resistance and flame retardance can be increased. Aryl alkylene type epoxy resins are epoxy resins having one or more aryl alkylene groups in a repeating unit thereof. The examples include xylylene type epoxy resins, anthracene type epoxy resins, biphenyl dimethylene type epoxy resins, naphthalene dimethylene type epoxy resins and naphthalene-modified cresol novolac epoxy resins. Among them, biphenyl dimethylene type epoxy resins, naphthalene-modified cresol novolac epoxy resins, anthracene type epoxy resins and naphthalene dimethylene type epoxy resins are preferable. Also, naphthol aralkyl type epoxy resins can be suitably used since they are excellent in low linear expansion, low-water absorption and mechanical strength.

A content of the epoxy resin is not particularly limited and is preferably 1 to 55% by weight, more preferably 5 to 40% by weight, with respect to the total content of the resin composition. If the content is less than the lower limit, there could be a decrease in reactivity of the cyanate resin or humidity resistance of the thus-obtained product. If the content exceeds the upper limit, there could be a decrease in low thermal expansion properties and heat resistance.

The weight average molecular weight of the epoxy resin is not particularly limited and is preferably 500 to 20,000, more preferably 800 to 15,000. If the weight average molecular weight is less than the lower limit, the surface of the resin layer could be tacky. If the weight average molecular weight exceeds the upper limit, there could be a decrease in solder heat resistance. By setting the weight average molecular weight within the above range, the resin layer can achieve an excellent balance among these properties. The weight average molecular weight of the epoxy resin can be measured by GPC, for example.

The thermosetting resins can be used alone or in combination of two or more kinds. In general, the thermosetting resin is used in combination with a curing agent.
A content of the thermosetting resin is not particularly limited and is preferably 20 to 90% by weight, more preferably 30 to 80% by weight, still more preferably 40 to 70% by weight of the resin composition for forming the resin layer. If the content is less than the lower limit, it could be difficult to form the resin layer. If the content exceeds the upper limit, there could be a decrease in strength of the resin layer.

The resin layer (or the resin composition for forming the resin layer) of the printed wiring board of the present invention can comprise an inorganic filler. It is preferable that the resin layer comprises the inorganic filler, from the point of view that low thermal expansion properties, high elasticity and low-water absorption are provided to the resin layer, resulting in an improvement in mounting reliability and warpage.
The inorganic filler preferably contains coarse particles having a diameter of more than 2 µm in an amount of 500 ppm or less, from the point of view that when the inorganic filler is used for the insulating layer of the wiring board, excellent groove and via hole formability by laser processing can be obtained, the groove being for forming a fine wiring having circuit width/circuit distance (L/S) of 10 µm/10 µm or less, as well as excellent adhesion between the thus-formed insulating layer and conductor circuit. More preferably, the inorganic filler contains coarse particles having a diameter of more than 2 µm in an amount of 300 ppm or less, still more preferably in an amount of 5 ppm or less.
A method for obtaining the inorganic filler containing coarse particles having a diameter of more than 2 µm in an amount of 500 ppm or less, is not particularly limited. The inorganic filler can be obtained by, for example, a method for eliminating coarse particles having a diameter of more than 2 µm, comprising the steps of: filtering coarse particles in a state of slurry in organic solvent and/or water for several times using a filter with small pore size that is 10 times or more larger than the average particle diameter; and repeating filtration for several times, using a filter with a small pore size of 2 µm to eliminate coarse particles having a diameter of more than 2 µm.

A coarse particle diameter and content of the inorganic filler can be measured by a particle image analyzer (product name: FPIA-3000S; manufactured by: SYSMEX CORPORATION). They can be measured by dispersing the inorganic filler in water or organic solvent by sonication and calculating the number of the inorganic filler having a diameter of more than 2 µm shown in an obtained image. In particular, the content of the inorganic filler can be defined by the number of particles having an equivalent circle diameter of more than 2 µm and the total number of analyzed particles.

More preferably, the inorganic filler has a maximum particle diameter of 2.0 µm or less. Thereby, the above-specified surface roughness of the resin layer is likely to be obtained, and a fine wiring with high insulation reliability and excellent signal response can be formed. The maximum particle diameter of the inorganic filler is not particularly limited and is preferably 1.8 µm or less, more preferably 1.5 µm or less. Thereby, the composite body can effectively exert the effect of increasing insulation reliability, signal response, plating adhesion inside the via hole and groove, and connection reliability between the layers.

The inorganic filler preferably has an average particle diameter of 0.05 µm or more and 1.0 µm or less. Thereby, a fine wiring with high insulation reliability and excellent signal response is likely to be formed. If the average particle diameter of the inorganic filler is within the range, excellent groove and fine via hole formability by laser processing can be obtained, the groove being for forming a fine wiring having circuit width/circuit distance (L/S) of 10 µm/10 µm or less, so that the above-specified surface roughness of the resin layer is likely to be obtained. The average particle diameter of the inorganic filler is preferably 0.05 µm or more and 0.60 µm or less, more preferably 0.05 µm or more and 0.50 µm or less, still more preferably 0.05 µm or more and 0.40 µm or less. Thereby, the composite body can effectively exert the effect of increasing insulation reliability, signal response, plating adhesion inside the via hole and groove, and connection reliability between the layers.

The average particle diameter of the inorganic filler can be measured by a laser diffraction scattering method, for example. It can be measured by dispersing the inorganic filler in water by sonication, preparing a particle size distribution of the inorganic filler based on volume by means of a laser diffraction particle size analyzer (product name: LA-500; manufactured by: HORIBA), and defining the thus-obtained median diameter as the average particle diameter. In particular, the average particle diameter of the inorganic filler can be defined by D50.

If the amount of the coarse particles having a diameter of more than 2 µm in the inorganic filler exceeds the upper limit, the inorganic filler disturbs laser processing, so that there could be an area where no groove can be formed, or the via hole could be misshapen or and the resin could have a crack. Moreover, due to detachment of the coarse particle filler, there could be a decrease in insulation reliability and plating adhesion. In addition, since it takes a longer time to form the via hole and groove with laser beam, there could be a decrease in workability. Moreover, due to the inorganic filler left on the side wall surface of the groove after the laser processing, the surface roughness of the electroconductive layer is increased after plating. Thereby, there could be a decrease in accuracy of the shape of the wiring and via hole, and the insulation reliability of the high density printed wiring board could be deteriorated. Furthermore, the signal response in the high-frequency region of over 1 GHz could be deteriorated by the skin effect. This could be caused even in the case where the average particle diameter of the inorganic filler exceeds the upper limit.

If the average particle diameter of the inorganic filler is less than the lower limit, there could be a decrease in physical properties of the resin layer, such as thermal expansion coefficient/elastic modulus, and thus in mounting reliability upon mounting a semiconductor element. Also, there could be a decrease in dispersibility of the inorganic filler in the resin composition for forming the resin layer, aggregation of the filler, and a difficulty in forming a resin film due to a decrease in flexibility of the resin composition in the state of B stage.

Examples of the inorganic filler include, but not particularly limited to: silicate salts such as talc, calcined clay, uncalcined clay, mica and glass; oxides such as titanium oxide, alumina, silica and fused silica; carbonates such as calcium carbonate, magnesium carbonate and hydrotalcite; hydroxides such as aluminum hydroxide, magnesium hydroxide, boehmite and calcium hydroxide; sulfates and sulfites such as barium sulfate, calcium sulfate and calcium sulfite; borates such as zinc borate, barium metaborate, aluminum borate, calcium borate and sodium borate; nitrides such as aluminum nitride, boron nitride, silicon nitride and carbon nitride; and titanates such as strontium titanate and barium titanate. As the inorganic filler, they can be used alone or in combination of two or more kinds. Among the above, in terms of having excellent low thermal expansion characteristics, flame retardance and elastic modulus, silica is preferred, and fused silica is more preferred. Among them, the shape is preferably spherical silica.

When the inorganic filler is contained in the resin layer or the resin composition for forming the resin layer, a content of the inorganic filler is preferably 10 to 80% by weight, more preferably 20 to 70% by weight, still more preferably 30 to 60% by weight of the resin layer or the resin composition for forming the resin layer, from the point of view that it is possible to form a fine wiring with high insulation reliability and excellent signal response.

As needed, the resin layer or the resin composition for forming the resin layer can contain additives other than the above components, such as a film-forming resin such as a thermoplastic resin, a curing accelerator, a coupling agent, a pigment, a dye, a defoaming agent, a leveling agent, an ultraviolet absorbing agent, a foaming agent, an antioxidant, a flame retardant and an ion scavenger.

Hereinafter, the resin composition for wiring board of the present invention will be described. The resin composition for wiring board of the present invention is a resin composition comprising an inorganic filler and a thermosetting resin, wherein the inorganic filler contains coarse particles having a diameter of more than 2 µm in an amount of 500 ppm or less.
Thereby, when the resin composition is used for the insulating layer of the multilayer printed wiring board, excellent groove and fine via hole formability by laser processing can be obtained, the groove being for forming a fine wiring having circuit width/circuit distance (L/S) of 10 µm/10 µm or less, as well as excellent adhesion between the thus-formed insulating layer and conductor circuit.
The resin composition for wiring board of the present invention is suitably used for forming the resin layer of the composite body of the present invention.

In the resin composition for the wiring board of the present invention, the inorganic filler preferably has a maximum particle diameter of 2.0 µm or less, from the point of view that the wiring board can effectively exert the effect of increasing insulation reliability, signal response, plating adhesion inside the via hole and groove, and connection reliability between the layers. The inorganic filler preferably has an average particle diameter of 0.05 µm or more and 1.0 µm or less, from the point of view that the wiring board has high insulation reliability and excellent signal response.

As the inorganic filler and thermosetting resin used for the resin composition for wiring board of the present invention, those mentioned above in connection with the resin layer of the composite body can be suitably used. Also, the resin composition for wiring board of the present invention can contain additives as described above in connection with the resin layer of the composite body, as needed.

In the resin composition for wiring board of the present invention, a content of the inorganic filler is preferably 10 to 80% by weight, more preferably 20 to 70% by weight, still more preferably 30 to 60% by weight of the resin composition, from the point of view that it is possible to form a fine wiring with high insulation reliability and excellent signal response. Moreover, in the resin composition for wiring board of the present invention, a content of the thermosetting resin is preferably 20 to 90% by weight, more preferably 30 to 80% by weight, still more preferably 40 to 70% by weight of the resin composition. If the content is less than the lower limit, it could be difficult to form the resin layer. If the content exceeds the upper limit, there could be a decrease in strength of the resin layer.

Next, the resin sheet for wiring board of the present invention will be described.
The resin sheet for wiring board of the present invention comprises a resin layer and a substrate, wherein the resin layer is on the substrate and comprises the resin composition for wiring board of the present invention.

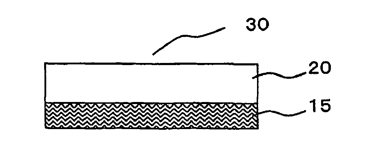

FIG. 4 is a schematic view of the resin sheet for wiring board of the present invention. Resin sheet 30 for wiring board comprises resin layer 20 and substrate 15, wherein resin layer 20 is on substrate 15 and comprises the resin composition for wiring board. The resin layer of the resin sheet for wiring board of the present invention is suitably used as a material for forming the resin layer of the composite body of the present invention.

Substrate 15 is not particularly limited and can be a polymer film or metal foil. Examples of the polymer film include, but not particularly limited to, films of heat-resistant thermoplastic resins including polyester resins such as polyethylene terephthalate and polybutylene terephthalate, fluorine resins and polyimide resins. Examples of the metal foil include, but not particularly limited to, metal foils of copper and/or copper alloys, aluminum and/or aluminum alloys, iron and/or iron alloys, silver and/or silver alloys, gold and/or gold alloys, zinc and/or zinc alloys, nickel and/or nickel alloys, and tin and/or tin alloys.

The thickness of resin layer 20 is not particularly limited and is preferably 1 µm or more and 60 µm or less, more preferably 5 µm or more and 40 µm or less. The thickness of the resin layer is preferably the lower limit or more from the viewpoint of increasing insulation reliability, and preferably the upper limit or less from the viewpoint of decreasing the thickness of a multilayer printed wiring board. Thereby, in the production of a printed wiring board, it is possible to form an insulating layer in which convexoconcaves of the electroconductive layer of the inner layer circuit board are filled, and to provide a suitable thickness to the insulating layer.

The thickness of the polymer film or metal foil used as the substrate is not particularly limited and is preferably 10 µm or more and 70 µm or less, from the point of view that handling is easy in the production of resin sheet 30.
To produce resin sheet 30 of the present invention, the surface of the substrate being in contact with the insulating layer preferably has a surface roughness that is as small as possible. Thereby, the surface of the insulating layer can be uniformly roughened and it is easy to form a fine wiring.

A method for producing resin sheet 30 of the present invention is not particularly limited, and the examples include the following: a method comprising the steps of dissolving and dispersing the resin composition of the present invention in a solvent or the like to prepare a resin varnish, applying the resin varnish on a substrate by means of a coater selected from various kinds of coaters, and drying the same; and a method comprising the steps of spraying a resin varnish onto a substrate by means of a spraying apparatus and drying the same. Among them, preferred is the method for applying the resin varnish onto a substrate by means of a coater selected from various kinds of coaters such as a comma coater and a die coater, and drying the same. Thereby, a resin sheet which causes no void and has a resin layer having a uniform thickness can be efficiently produced.

It is desirable that the solvent used for the resin varnish has excellent properties to dissolve the resin components of the resin composition. However, a poor solvent can be used to the extent that it exerts no negative effect. Examples of the solvent having good solubility include acetone, methyl ethyl ketone, methyl isobutyl ketone, cyclohexanone, tetrahydrofuran, dimethylformamide, dimethylacetamide, dimethylsulfoxide, ethylene glycol, cellosolves and carbitols. A solid content of the resin varnish is not particularly limited and is preferably 30 to 80% by weight, more preferably 40 to 70% by weight.

Next, a method for producing the composite body of the present invention will be described.
In the method for producing the composite body of the present invention, first, a resin layer is prepared. A method for forming the resin layer employed in the method for producing the composite body of the present invention, will be described. As an example, there will be described, but not limited to, a method for forming the resin layer on a printed wiring board. The method for forming the resin layer on a printed wiring board is not particularly limited, and it is preferable to use the resin sheet of the present invention or to obtain a resin sheet with a carrier film by the same method as that of the resin sheet of the present invention.

The resin layer can be formed by hot-pressing the thus-obtained resin sheet with the carrier film to the substrate such as a printed wiring board with a laminator, a vacuum press machine or the like. Also, the resin layer can be formed by applying a resin varnish directly onto the substrate. In the case of forming the resin layer on, for example, one other than the printed wiring board, such as a wafer, the resin layer can be formed by, as described above, the method comprising the steps of preparing the resin sheet with the carrier film and hot-pressing the same, or the method comprising the steps of applying the resin varnish. As the solvent used for the resin varnish, those that are mentioned above in connection with the resin sheet of the present invention can be used.
Also, the resin layer of the composite body is formed by heat curing the thermosetting resin as needed before and/or after forming the electroconductive layer.

Next, the method for producing the composite body of the present invention will be described with reference to figures.

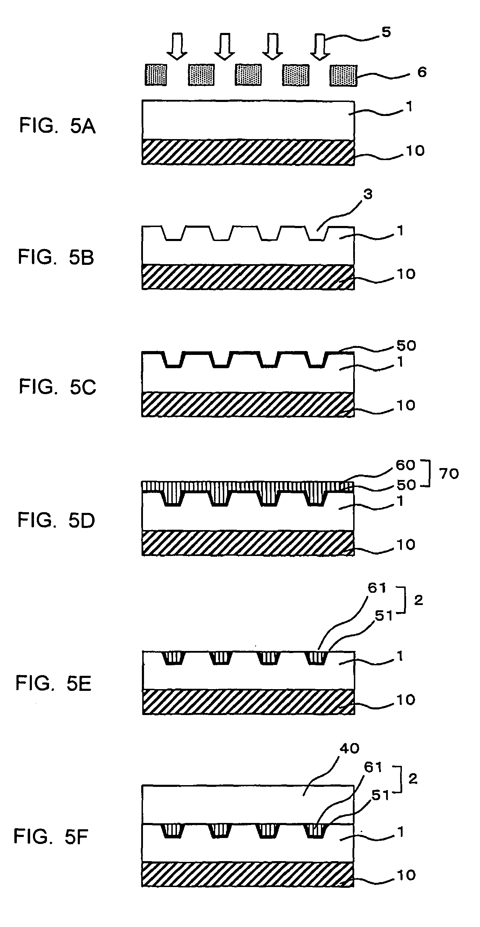

FIGS. 5A to 5F are schematic views showing an example of the method for producing the first embodiment of the composite body of the present invention, comprising the resin layer and the electroconductive layer. The method for producing the composite body of the present invention is a method for producing a composite body comprising resin layer 1 and electroconductive layer 2, and comprises: (A) a step of forming groove 3 having an inner surface with an arithmetic average roughness (Ra) of 0.05 µm or more and 0.45 µm or less on a surface of resin layer 1 with laser beam 5 (FIGS. 5A and 5B), (B) a step of forming an electric conductor (electroless plating layer 50) on the surface of resin layer 1 by electroless plating (FIG. 5C), and (C) a step of forming electroconductive layer 2 only in groove 3 on resin layer 1 by removing part of electric conductor 70.

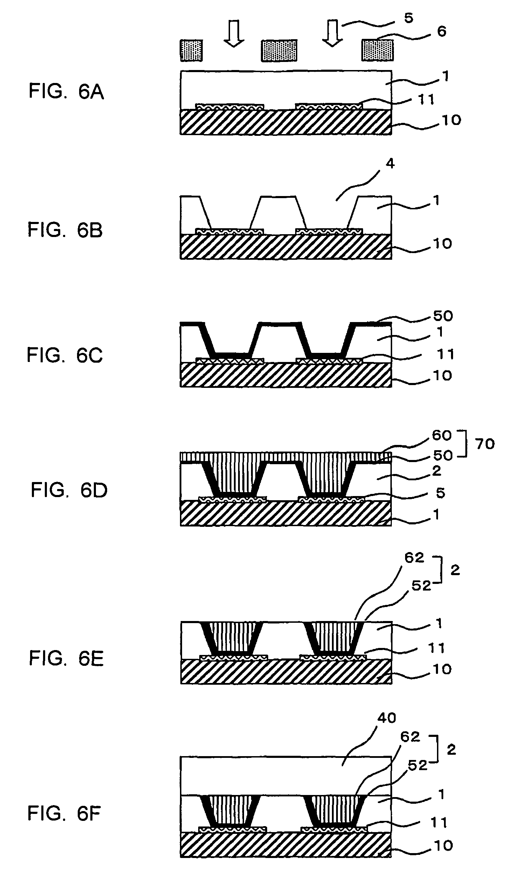

FIGS. 6A to 6F are schematic views showing an example of the method for producing the second embodiment of the composite body of the present invention, comprising the resin layer and the electroconductive layer. The method for producing the composite body of the present invention is a method for producing a composite body comprising resin layer 1 and electroconductive layer 2, and comprises: (A) a step of forming via hole 4 having an inner surface with an arithmetic average roughness (Ra) of 0.05 µm or more and 0.45 µm or less in resin layer 1 with laser beam 5 (FIGS. 6A and 6B), (B) a step of forming electroless plating layer 50 on a surface of resin layer 1 by electroless plating (FIG. 6C), and (C) a step of forming electroconductive layer 2 only in via hole 4 of resin layer 1 by removing part of electric conductor 70.

In the step (A), laser beam 5 is preferably excimer laser or YAG laser. By using the laser, it is possible to form well-shaped groove 3 and via hole 4 with accuracy and thus to form a fine wiring and increase density. A laser wavelength of the excimer laser is not particularly limited and is preferably 193 nm, 248 nm or 308 nm, more preferably 193 nm or 248 nm. Thereby, the composite body of the present invention can effectively exert the effect of forming a well-shaped groove and via hole with accuracy. The YAG laser preferably has a wavelength of 355 nm. At other wavelengths, the resin composition constituting resin layer 1 may not absorb laser beam 5, and no grooves and via holes may be formed. Laser beam 5 is applied to resin layer 1 through mask 6.
A condition for applying the laser is selected so as to form a groove and via hole on the surface of the resin layer, in which a surface of the inside of the groove and via hole has an arithmetic average roughness (Ra) of 0.05 µm or more and 0.45 µm or less. In particular, the condition is preferably a condition so that the surface of the inside of groove 3 and via hole 4 on the resin layer has an arithmetic average roughness (Ra) of 0.05 µm or more and 0.30 µm or less, and more preferably a condition so as to have an arithmetic average roughness (Ra) of 0.1 µm or more and 0.25 µm or less. Thereby, the composite body of the present invention can effectively exert the effects of increasing insulation reliability and signal response, decreasing transmission loss, and decreasing plating failure inside groove 3 and via hole 4 and connection failure between the layers.

Preferably, the method for producing the composite body of the present invention comprises a step of performing desmear with plasma or chemical solution between the steps (A) and (B). Thereby, upon forming groove 3 and via hole 4 with laser beam 5, it is possible to remove carbide left on the side wall surface of groove 3 and via hole 4 and thus to form a fine wiring and via hole with high electrical reliability.

Examples of the plasma include, but not particularly limited to, nitrogen plasma, oxygen plasma, argon plasma, tetrafluoromethane plasma, and plasma of mixed gas thereof. As a plasma treatment condition, preferred is a condition so that the surface of the resin layer and the surface of the inside of the groove and via hole have an arithmetic average roughness (Ra) of 0.05 µm or more and 0.45 µm or less after the plasma process and, at the same time, carbide left on the surface of the inside of groove 3 and via hole 4 can be fully removed. Thereby, it is possible to form a via hole with high insulation reliability and excellent signal response. In the high-frequency region of over 1 GHz, it is possible to decrease transmission loss due to the skin effect and to decrease plating failure inside the via hole and connection failure between the layers. The plasma condition is not particularly limited and is preferably a condition so that the surface of the inside of groove 3 and via hole 4 of the resin layer has an arithmetic average roughness (Ra) of 0.05 µm or more and 0.30 µm or less after the plasma process, more preferably a condition so as to have an arithmetic average roughness (Ra) of 0.1 µm or more and 0.25 µm or less. Thereby, the composite body of the present invention can effectively exert the effects of increasing insulation reliability and signal response, decreasing transmission loss, and decreasing plating failure inside the groove 3 and via hole 4 and connection failure between the layers.

The desmear with chemical solution can, but not particularly limited to, use permanganate, dichromate, etc. A condition for the desmear treatment is preferably a condition so that the surface of the resin layer and the surface of the inside of the groove and via hole have an arithmetic average roughness (Ra) of 0.05 µm or more and 0.45 µm or less after the desmear step and, at the same time, carbide left on the surface of the inside of groove 3 and via hole 4 can be fully removed. Thereby, it is possible to form a via hole having high insulation reliability and excellent signal response and being effective in decreasing plating failure inside the via hole and connection failure between the layerse. In the high-frequency region of over 1 GHz, it is possible to decrease transmission loss due to the skin effect. The desmear condition is not particularly limited and is preferably a condition so that the surface of the inside of groove 3 and via hole 4 of the resin layer have an arithmetic average roughness (Ra) of 0.05 µm or more and 0.30 µm or less, still more preferably 0.1 µm or more and 0.25 µm or less, after the desmear step. Thereby, the composite body of the present invention can effectively exert the effects of increasing insulation reliability and signal response, decreasing transmission loss, and decreasing plating failure inside groove 3 and via hole 4 and connection failure between the layers.

If the desmear step with plasma or chemical solution is insufficient and carbide is thus left on the surface of the inside of groove 3 and via hole 4, there could be a decrease in insulation reliability of the composite body. If the desmear step with plasma or chemical solution is excessive, there is an increase in arithmetic average roughness (Ra) of the surface of the inside of groove 3 and via hole 4 of resin layer 1, which is in contact with electroconductive layer 2; therefore, due to the surface roughness of electroconductive layer 2, there could be a deterioration in signal response of the wiring due to the skin effect, or there could be plating failure inside groove 3 and via hole 4 and connection failure between the layers.

In the step (B) of the present invention, electroless plating layer 50 is formed on the surface of resin layer after the step of performing desmear on the resin layer with plasma or chemical solution.

A type of metal of electroless plating layer 50 is not particularly limited and is preferably copper, nickel or the like. These metals can provide excellent adhesion between resin layer 1 and electroless plating layer 50. A thickness of the electroless plating layer is not particularly limited and is preferably about 0.1 µm or more and 5 µm or less. The adhesion between the resin layer and the electroless plating layer can be further increased by further performing heating treatment at 150 to 200°C for 10 to 120 minutes with a hot air drying machine after electroless plating.

Preferably, the method for producing the composite body of the present invention comprises a step of further forming electrolytic plating layer 60 by electrolytic plating between the steps (B) and (C). In this step, the inside of groove 3 and via hole 4 formed by laser beam 5 can be filled with electrolytic plating layer 60.

As the electrolytic plating, copper sulfate electrolytic plating can be used. The plating solution is not particularly limited, and it preferably contains an additive such as a leveling agent, polymer or brightener. Thereby, a plating is preferentially deposited inside groove 3 and via hole 4 formed in resin layer 1 to fill the groove and via hole with electrolytic plating layer 60, so that a level of plating deposition on the surface of the resin layer after the electrolytic plating is equal to that of plating deposition on groove 3 and via hole 4 after the same. A thickness of the electrolytic plating layer is not particularly limited and is preferably about 5 µm or more and 25 µm or less from the surface of resin layer 1.

In the step (C) of the present invention, electroconductive layer 2 is formed only in groove 3 and via hole 4 of resin layer 1 by removing part of electric conductor 70 that is formed by electroless and electrolytic plating. A method for removing part of electric conductor 70 formed by electrolytic plating is not particularly limited, and is preferably a chemical etching treatment, a polishing treatment, a buff polishing treatment or the like. Thereby, it is possible to effectively remove only electric conductor 70 on the surface of the resin layer and thus to leave electroconductive layer 2 only in groove 3 and via hole 4.
Therefore, it is possible to produce a composite body with excellent electrical reliability, excellent signal response, excellent plating adhesion inside the groove and via hole, and excellent connectivity between the layers.

The production method of the present invention can comprise, after the step (C), (D) a step of forming different resin layer 40 on resin layer 1 and electroconductive layer 2.

In the step (D) of the present invention, by forming different resin layer 40 on resin layer 1 and electroconductive layer 2, each electroconductive layer to be a wiring of the multilayer printed wiring board is covered with the resin layer, thereby ensuring insulation properties between wirings or via holes. A method for forming different resin layer 40 on resin layer 1 and electroconductive layer 2 is not particularly limited, and an example thereof is a method that uses, as in the case of preparing resin layer 1, a resin layer with a carrier film and, for example, a vacuum press laminator, plate press machine or the like.

As described above, by repeating the above steps (A), (B), (C) and (D), it is possible to produce a multilayered composite body with excellent electrical reliability, excellent signal response, excellent plating adhesion inside the groove and via hole, and excellent connectivity between the layers.

Next, the semiconductor device will be described.
The semiconductor device of the present invention comprises the composite body of the present invention and a semiconductor element mounted thereon, wherein the composite body is a printed wiring board or metal core wiring board.
A semiconductor element having a solder bump is mounted on the composite body of the present invention, such as a printed wiring board, and the composite body (e.g., printed wiring board) is connected to the semiconductor element through the solder bump. Then, a liquid encapsulating resin is filled between the composite body (e.g., printed wiring board) and the semiconductor element, thereby producing the semiconductor device.

The solder bump is preferably made of alloy comprising tin, lead, silver, copper, bismuth or the like. A method for connecting the semiconductor element with the composite body (e.g., printed wiring board) is as follows: the position of an electrode for connection on the composite body (e.g., printed wiring board) is aligned with that of the solder bump of the semiconductor element by means of a flip chip bonder, etc., and the solder bump is heated to a temperature that is higher than the melting point by means of an IR reflow device, a hot plate or any other heating device to fusion-bond the solder bump and the composite body (e.g., printed wiring board) together, thereby connecting the semiconductor element with the composite body. For better connection reliability, a layer of relatively-low-melting-point metal, such as a solder paste, can be preliminarily formed on the electrode for connection on the composite body (e.g., printed wiring board). Connection reliability can be also increased by applying a flux on the solder bump and/or the surface of the electrode for connection on the composite body (e.g., printed wiring board) before the above connecting process.

### Examples

Hereinafter, the present invention will be explained with reference to examples and comparative examples. However, the present invention is not limited thereto.

### Example series I: Production of composite body of the first embodiment and semiconductor device

### <Example I-1>

The following were dissolved and dispersed in methyl ethyl ketone: 20 parts by weight of a novolac type cyanate resin (product name: Primaset PT-30; manufactured by: Lonza Japan Ltd.; weight-average molecular weight: about 700), 35 parts by weight of a methoxynaphthalene dimethylene type epoxy resin (product name: EXA-7320; manufactured by: Dainippon Ink & Chemicals, Inc.), 5 parts by weight of a phenoxy resin (product name: jER4275; manufactured by: Japan Epoxy Resins Co., Ltd.), and 0.2 part by weight of an imidazole compound (product name: CUREZOL 1B2PZ (1-benzyl-2-phenylimidazole); manufactured by: Shikoku Chemicals Corporation). To the thus-obtained dispersion, 40 parts by weight of an inorganic filler (spherical fused silica) having an average particle diameter of 0.4 µm was added, the filler being obtained by filtering an inorganic filler (spherical fused silica) (product name: SFP-20M; manufactured by: Denki Kagaku Kogyo Kabushiki Kaisha) with a lamination type cartridge filter (manufactured by: Sumitomo 3M Limited) to eliminate particles having a diameter more than the maximum particle diameter of 2.0 µm. Then, 0.2 part by weight of a coupling agent (epoxy silane coupling agent) (product name: A-187; manufactured by: GE Toshiba Silicones Co., Ltd.) was further added thereto and agitated for 10 minutes by means of a high speed agitator, thereby producing a resin varnish having a solid content of 50% by weight.

The thus-obtained resin varnish was applied onto one surface of a 25 µm thick PET (polyethylene terephthalate) film by means of a comma coater so that the resulting resin film has a thickness of 40 µm when dried, and dried by means of a drying machine at 160°C for 10 minutes, thereby producing a resin layer with a carrier film.

A core substrate having an electroconductive layer on both surfaces thereof was sandwiched by the above-obtained resin layers with the carrier film. The resultant was heat-pressed under vacuum at a temperature of 100°C and a pressure of 1 MPa by means of a vacuum press laminator, followed by heat-curing at 180°C for 45 minutes by means of a hot air drying machine, thereby obtaining the substrate with the resin layers.
As the core substrate having the electroconductive layer on both surfaces thereof, the following was used:
Resin layer: Halogen free core substrate (thickness: 0.4 mm)
Electroconductive layer: Copper foil (thickness: 18 µm; circuit width/circuit distance (L/S): 120/180 µm; clearance hole: 1 mmϕ and 3 mmϕ; slit: 2 mm)

By means of excimer laser having a wavelength of 193 nm, grooves having a target width of 10 µm and target depth of 15 µm were formed on the resin layers on both surfaces of the substrate.
Processing condition was set as follows:
Mask: 50 µm width slit mask
Frequency: 100 Hz
Energy: 500 mJ/cm²
Scan rate: 65 µm/sec

The substrate with the resin layers having the grooves formed thereon, was immersed in a swelling agent (product name: Swelling Dip Securiganth P500; manufactured by: Atotech Japan K.K.) at 60°C for 10 minutes, without removal of the carrier films. In addition, the substrate was immersed in a potassium permanganate aqueous solution (product name: Concentrate Compact CP; manufactured by: Atotech Japan K.K.) at 80°C for 20 minutes, followed by neutralization to perform a desmear treatment.

Next, after removal of the carrier films, the substrate was subjected to the processes of degreasing, providing a catalyst and activation. Thereafter, an electroless copper plating layer having a thickness of about 0.2 µm was formed on the substrate.

Next, electrolytic copper plating (product name: Top Lucina α; manufactured by: Okuno Chemical Industries Co., Ltd.) was performed at 3 A/dm² for 30 minutes using the electroless copper plating layer as an electrode, thereby forming a electroconductive layer having a thickness of about 5 µm on the surface of the resin layer.

The electroconductive layer present on the surface of the resin layer was removed by a quick etching treatment (product name: SAC process; manufactured by: Ebara Densan Ltd.) to ensure insulation between wirings. Then, the insulation resin layer was completely cured at 200°C for 60 minutes.

At last, a solder resist (product name: PSR4000/AUS308; manufactured by: Taiyo Ink Mfg. Co., Ltd.) was formed on a circuit surface, thereby producing a four-layered printed wiring board.

### <Example I-2>

A four-layered printed wiring board was produced similarly as in Example I-1, except that grooves having a width of 10 µm and depth of 15 µm were formed on the resin layers of the substrate by excimer laser having a wavelength of 248 nm.

### <Example I-3>

A four-layered printed wiring board was produced similarly as in Example I-1, except that grooves having a width of 10 µm and depth of 15 µm were formed on the resin layers of the substrate by YAG laser having a wavelength of 355 nm.

### <Comparative example I-1>

A four-layered printed wiring board was produced similarly as in Example I-1, except that a general purpose, epoxy resin-based build-up material (product name: GX-13; manufactured by: Ajinomoto Co., Inc.; maximum particle diameter of inorganic filler: 2.5 µm; coarse particles of inorganic filler having a diameter of more than 2 µm: 8,000 ppm; average particle diameter of inorganic filler: 0.5 µm) was used as a resin layer.

### <Comparative example I-2>

A four-layered printed wiring board was produced similarly as in Example I-1, except that a general purpose, epoxy resin-based build-up material (product name: GX-13; manufactured by: Ajinomoto Co., Inc.; maximum particle diameter of inorganic filler: 2.5 µm; coarse particles of inorganic filler having a diameter of more than 2 µm: 8,000 ppm; average particle diameter of inorganic filler: 0.5 µm) was used as a resin layer, ; and grooves having a width of 10 µm and depth of 15 µm were formed on the resin layers of the substrate by YAG laser having a wavelength of 355 nm.

### <Evaluation>

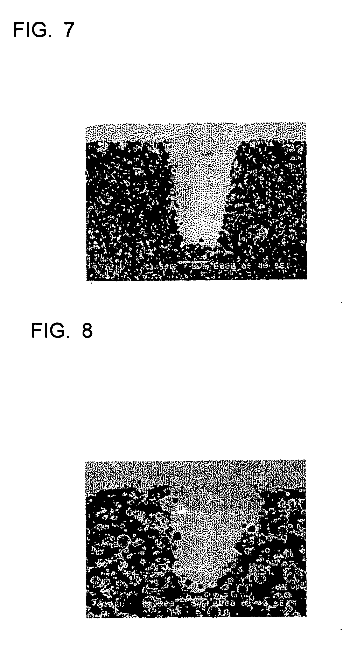

The maximum width and cross-sectional shape of the electroconductive layer were determined by cutting each of the multilayer wiring boards obtained in Examples and Comparative examples lengthwise and observing the cut surface with a microscope. The arithmetic average roughness (Ra) of the surface of the grooves formed on the resin layer was measured with WYKO NT1100 (product name; manufactured by: Veeco Instruments Inc.) in accordance with JIS B0601 after removing the electroconductive layer by etching. The thus-obtained results are shown in Table 1. As for Example I-1 and Comparative example I-1, FIGS. 7 and 8 show photographs of cross-sectional shapes at the stage of forming grooves on the resin layer with laser and electric conductors by electroless plating/electrolytic plating.

**[Table 1]**

| | Example I-1 | Example I-2 | Example I-3 | Comparative example I-1 | Comparative example I-2 |
|---|---|---|---|---|---|
| Maximum particle diameter of filler | 2.0 µm | 2.0 µm | 2.0 µm | 2.5 µm | 2.5 µm |
| Type of laser | Excimer | Excimer | YAG | Excimer | YAG |
| Wavelength region | 193 nm | 248 nm | 355 nm | 193 nm | 355 nm |
| Average roughness of resin layer | 0.05 µm | 0.1 µm | 0.2 µm | 0.5 µm | 0.55 µm |
| Maximum width of electroconductive layer | 10 µm | 10 µm | 10 µm | 11 µm | 12 µm |
| Cross-sectional shape of electroconductive layer | Approximate trapezoidal shape | Approximate trapezoidal shape | Triangular shape | Approximate trapezoidal shape | Triangular shape |
| Semiconductor device | ⊚ | ⊚ | ○ | × | × |

As is clear from Table 1, in each of Examples I-1 to I-3, the resin layer achieved an average roughness (Ra) of 0.05 µm or more and 0.45 µm or less, and the electroconductive layer achieved a maximum width of 10 µm so that a pattern having a wiring pitch of 10 µm can be formed; moreover, fine wirings having excellent insulation reliability and excellent signal response even in the high-frequency region, were formed. On the other hand, in each of Comparative examples I-1 to I-2, the resin layer had an average roughness (Ra) of 0.5 µm or more, so that signal loss becomes large in transmission in the high-frequency region; moreover, the electroconductive layer had a large maximum width, so that no pattern with a wiring pitch of 10 µm was formed.

### <Production of semiconductor device>

A semiconductor device was produced using the multilayer printed wiring board obtained in each of Examples and Comparative examples.
A semiconductor element (TEG chip, size: 15 mm × 15 mm; thickness: 0.725 mm), solder bumps having a diameter of 100 µm, being formed a pitch of 150 µm and comprising a Sn/Pb eutectic, and a circuit protection film comprising a positive photosensitive resin (product name: CRC-8300; manufactured by: Sumitomo Bakelite Co., Ltd.) were used. The semiconductor device was produced as follows: a flux material was uniformly applied onto the solder bumps by a transfer method; the semiconductor element was mounted on the multilayer printed wiring board obtained in each of Examples and Comparative examples by hot-pressing with a flip chip bonder; the solder bumps were fusion-bonded to the board in an IR reflow furnace; and a liquid encapsulating resin (product name: CRP-4152S; manufactured by: Sumitomo Bakelite Co., Ltd.) was filled between the multilayer printed wiring board and semiconductor element and cured, thereby obtaining the semiconductor device. The liquid encapsulating resin was cured under the condition of a temperature of 150°C and a time of 120 minutes.

### <Evaluation of semiconductor device>

In accordance with J-STD-20 of IPC/JEDEC, each of the semiconductor devices obtained above was subjected to a pretreatment under the condition of a temperature of 30°C, a humidity of 60% and a time of 192 hours. Thereafter, it was passed through a reflow furnace at a temperature of 260°C three times, and then subjected to a posttreatment of 500 cycles of -50°C for 30 minutes and 125°C for 30 minutes. Each of the semiconductor devices is evaluated with respect to conduction resistance of the semiconductor elements and cross-sectional observation after the pretreatment and after the posttreatment of 500 cycles. Evaluation results are shown in Table 1.
Symbols shown in Table 1 refer to the following:
⊚: There is no problem with conduction resistance after the posttreatment of 500 cycles, and problems with conductor circuit and via hole were not observed by cross-sectional observation
○: There is an increase in conduction resistance in the range of 1 to less than 10% after the posttreatment of 500 cycles; however, problems with conductor circuit and via hole were not observed by cross-sectional observation
×: There is an increase in conduction resistance by 10% or more after the posttreatment of 500 cycles, compared to connection resistance before posttreatment.
Or, a microvoid and/or peeling crack was observed between conductor circuit and resin or between via hole and resin.

As is clear from Table 1, the semiconductor devices obtained in Examples I-1 to I-3 had high adhesion and reliability. On the other hand, in Comparative examples I-1 to I-2, there was an increase in conduction resistance; adhesion was poor; and a peeling crack was observed.

### Example series II: Production of composite body of the second embodiment and semiconductor device

### <Example II-1>

The followings were dissolved and dispersed in methyl ethyl ketone: 20 parts by weight of a novolac type cyanate resin (product name: Primaset PT-30; manufactured by: Lonza Japan Ltd.; weight-average molecular weight: about 700), 35 parts by weight of a methoxynaphthalene dimethylene type epoxy resin (product name: EXA-7320; manufactured by: DAINIPPON INK & CHEMICALS, INC.), 5 parts by weight of a phenoxy resin (product name: jER4275; manufactured by Japan Epoxy Resins Co., Ltd.), and 0.2 part by weight of an imidazole compound (product name: CUREZOL 1B2PZ (1-benzyl-2-phenylimidazole). To the thus-obtained dispersion, 40 parts by weight of an inorganic filler (spherical fused silica) having an average particle diameter of 0.4 µm was added, the filler being obtained by filtering an inorganic filler (spherical fused silica) (product name: SFP-20M; manufactured by: DENKI KAGAKU KOGYO KABUSHIKI KAISHA) with a lamination type cartridge filter (manufactured by: Sumitomo 3M Limited) to eliminate particles having a diameter more than the maximum particle diameter of 2.0 µm. Then, 0.2 part by weight of a coupling agent (epoxy silane coupling agent) (product name: A-187; manufactured by: GE Toshiba Silicones Co., Ltd.) was further added thereto and agitated for 10 minutes by means of a high speed agitator, thereby producing a resin varnish having a solid content of 50% by weight.

The thus-obtained resin varnish was applied onto one surface of a 25 µm thick PET (polyethylene terephthalate) film by means of a comma coater so that the resulting resin film has a thickness of 20 µm when dried, and dried by means of a drying machine at 160°C for 10 minutes, thereby producing a resin sheet with a carrier film.

A core substrate having an electroconductive layer on both surfaces thereof was sandwiched by the above-obtained resin sheets with the carrier film. The resultant was heat-pressed under vacuum at a temperature of 100°C and a pressure of 1 MPa by means of a vacuum press laminator, followed by heat-curing at 180°C for 45 minutes by means of a hot air drying machine, thereby obtaining the substrate with the resin layers.
As the core substrate having the electroconductive layer on both surfaces thereof, the following was used:
Resin layer: Halogen free core substrate (thickness: 0.4 mm)
Electroconductive layer: Copper foil (thickness: 18 µm; circuit width/circuit distance (L/S): 120/180 µm; clearance hole: 1mmϕ and 3mmϕ; slit: 2 mm)

By means of excimer laser (product name: ATLEX-300SI; manufactured by: BEAMS, INC.) having a wavelength of 193 nm (ArF), via holes having a diameter of 25 µm were formed on the resin layers on both surfaces of the substrate at intervals of 0.1 mm.
Processing condition was set as follows:
Mask diameter: 200 µm
Frequency: 100 Hz
Energy: 100 mJ/cm²
The number of shots: 90

By means of excimer laser having a wavelength of 193 nm (ArF), grooves having a target width of 10 µm and target depth of 15 µm were formed on the resin layers on both surfaces of the substrate.
Processing condition was set as follows:
Mask: 50 µm width slit mask
Frequency: 100 Hz
Energy: 500 mJ/cm²
Scan rate: 65 µm/sec

The substrate with the resin layers having the via holes and grooves formed thereon, was immersed in a swelling agent (product name: Swelling Dip Securiganth P500; manufactured by: Atotech Japan K.K.) at 60°C for 10 minutes, without removal of the carrier films. In addition, the substrate was immersed in a potassium permanganate aqueous solution (product name: Concentrate Compact CP; manufactured by: Atotech Japan K.K.) at 80°C for 20 minutes, followed by neutralization to perform a desmear treatment.

Next, after removal of the carrier films, the substrate was subjected to the processes of degreasing, providing a catalyst and activation. Thereafter, an electroless copper plating layer having a thickness of about 0.2 µm was formed on the substrate.

Next, electrolytic copper plating (product name: Top Lucina α; manufactured by: Okuno Chemical Industries Co., Ltd.) was performed at 3 A/dm² for 30 minutes using the electroless copper plating layer as an electrode, thereby forming an electric conductor having a thickness of about 5 µm on the surface of the resin layer.

The electric conductor present on the surface of the resin layer was removed by a quick etching treatment (SAC process manufactured by: Ebara Densan Ltd.) to ensure insulation between via holes and that between wirings. Then, the insulation resin layer was completely cured at 200°C for 60 minutes.

The fine wirings having circuit width/circuit distance (L/S) of 10 µm/10 µm or less and the via holes were connected by an extraction electroconductive layer.
At last, a solder resist (product name: PSR4000/AUS308; manufactured by: Taiyo Ink Mfg. Co., Ltd.) was formed on a circuit surface, thereby producing a four-layered printed wiring board.

### <Example II-2>

A four-layered printed wiring board was produced similarly as in Example II-1, except that the mask diameter for forming via holes was 150 µm.

### <Example II-3>

A four-layered printed wiring board was produced similarly as in Example II-1, except that the mask diameter for forming via holes was 100 µm.

### <Example II-4>

A four-layered printed wiring board was produced similarly as in Example II-1, except that the mask diameter for forming via holes was 50 µm.

### <Example II-5>

A four-layered printed wiring board was produced similarly as in Example II-1, except that excimer laser having a wavelength of 248 nm (KrF) was used to form via holes and grooves.

### <Example II-6>

A four-layered printed wiring board was produced similarly as in Example II-1, except that YAG laser (product name: LU-2G121/2C; manufactured by: Hitachi Via Mechanics, Ltd.) having a wavelength of 355 nm was used to form via holes and grooves.

### <Example II-7>

A four-layered printed wiring board was produced similarly as in Example II-1, except that the thickness of the resin film was 10 µm, and the number of shots for forming via holes was 50.

### <Example II-8>

A four-layered printed wiring board was produced similarly as in Example II-1, except that the thickness of the resin film was 15 µm, and the number of shots for forming via holes was 70.

### <Comparative example II-1>

A four-layered printed wiring board was produced similarly as in Example II-1, except that an epoxy resin-based build-up material (product name: GX-13; manufactured by: Ajinomoto Co., Inc.; maximum particle diameter of inorganic filler: 2.5 µm; coarse particles of inorganic filler having a diameter of more than 2 µm: 8,000 ppm; average particle diameter of inorganic filler: 0.5 µm) was used as a resin layer.

### <Comparative example II-2>

A four-layered printed wiring board was produced similarly as in Example II-1, except that YAG laser having a wavelength of 355 nm was used.

Evaluation methods are as follows. The results are shown in Table 2.

### 1. Top diameter of via hole

The top diameter of the via holes was measured by observing a top surface of the via holes in the resin layer by means of a scanning electron microscope (SEM), after the desmear treatment and removal of the carrier film.

### 2. Arithmetic average roughness (Ra) of resin surface of inside of via hole or groove

The via hole of the four-layered printed wiring board was cut in a vertical cross-section direction. After the electroconductive layer was removed by etching, the resin surface of the inside of the via hole was measured with WYKO NT1100 (product name; manufactured by: Veeco Instruments Inc.) in accordance with JIS B0601.

The arithmetic average roughness (Ra) of the groove surface was measured as follows: in the cross-section of the groove cut in a conductor circuit direction, the electroconductive layer was removed by etching, and the resin surface of the inside of the groove was measured with WYKO NT1100 (product name; manufactured by: Veeco Instruments Inc.) in accordance with JIS B0601.

### 3. Connection reliability test

While treating the four-layered printed wiring board having a via wall distance of 0.1 mm under the condition of a temperature of 135°C, a humidity of 85% RH and an applied voltage of 50 V for 200 hours, insulation resistance between via holes was monitored.
Symbols shown in Table 2 refer to the following:
○: 1.0×10⁹ Q or more
×: Less than 1.0×10⁹ Ω

### 4. Plating adhesion

The plating adhesion inside the via hole was measured by cutting the via hole of the four-layered printed wiring board lengthwise and observing the cut surface by means of a scanning electron microscope (SEM). Symbols shown in Table 2 refer to the following:
○: Plating is tightly filled inside the via hole and there is no practical problem.
×: Microvoid is observed in the plating inside the via hole and there is a practical problem.

**[Table 2]**

| | Example II-1 | Example II-2 | Example II-3 | Example II-4 | Example II-5 | Example II-6 | Example II-7 | Example II-8 | Comparative example II-1 | Comparative example II-2 |
|---|---|---|---|---|---|---|---|---|---|---|
| Maximum particle diameter of filler | 2.0 µm | 2.0 µm | 2.0 µm | 2.0 µm | 2.0 µm | 2.0 µm | 2.0 µm | 2.0 µm | 2.5 µm | 2.5 µm |
| Type of laser | Excimer | Excimer | Excimer | Excimer | Excimer | YAG | Excimer | Excimer | Excimer | YAG |
| Wavelength of laser | 193 nm | 193 nm | 193 nm | 193 nm | 248 nm | 355 nm | 193 nm | 193 nm | 193 nm | 355 nm |
| Top diameter of via | 25 µm | 20 µm | 15 µm | 10 µm | 25 µm | 25 µm | 25 µm | 25 µm | 25 µm | 25 µm |
| Roughness (Ra) of resin surface of the inside of via hole | 0.05 µm | 0.05 µm | 0.05 µm | 0.05 µm | 0.1 µm | 0.25 µm | 0.05 µm | 0.05 µm | 0.5 µm | 0.60 µm |
| Roughness (Ra) of resin surface of the inside of groove of fine wiring | 0.05 µm | 0.05 µm | 0.05 µm | 0.05 µm | 0.1 µm | 0.2 µm | 0.05 µm | 0.05 µm | 0.5 µm | 0.55 µm |
| Connection reliability test | ○ | ○ | ○ | ○ | ○ | ○ | ○ | ○ | × | × |
| Plating adhesion | ○ | ○ | ○ | ○ | ○ | ○ | ○ | ○ | × | × |
| Semiconductor device | ⊚ | ⊚ | ⊚ | ⊚ | ⊚ | ○ | ⊚ | ⊚ | × | × |

As is clear from Table 2, in each of Examples II-1 to II-8, such an excellent via hole could be formed that the average roughness (Ra) of the resin layer of the inside of the via hole and groove 0.05 µm or more and 0.45 µm or less; it was possible to form the via hole having a diameter of 25 µm or less; and the via hole has excellent insulation reliability and signal response, and effectively exerts the effect of decreasing plating failure inside the via hole and connection failure between the layers. Also, such a pattern could be formed that the electroconductive layer has a maximum width of 10 µm and a wiring pitch of 10 µm; moreover, such a good fine wirings was formed that has excellent insulation reliability and excellent signal response even in the high-frequency region. On the other hand, in each of Comparative examples II-1 to II-2, the resin layer had an average roughness (Ra) of 0.5 µm or more, and a practical problem occurred in connection reliability test and with plating adhesion. Also in each of Comparative examples II-1 to II-2, the maximum width of the electroconductive layer was increased, thereby failing to form a pattern having a wiring pitch of 10 µm.

### <Production of semiconductor device>

A semiconductor device was produced using the multilayer printed wiring board obtained in each of Examples and Comparative examples.
A semiconductor element (TEG chip, size: 15 mm × 15 mm; thickness: 0.725 mm), solder bumps having a diameter of 120 µm, being formed at a pitch of 150 µm and comprising a Sn/Pb eutectic, and a circuit protection film comprising a positive photosensitive resin (product name: CRC-8300; manufactured by: Sumitomo Bakelite Co., Ltd.) were used. The semiconductor device was produced as follows: a flux material was uniformly applied onto the solder bumps by a transfer method; the semiconductor element was mounted on the multilayer printed wiring board obtained in each of Examples and Comparative examples by hot-pressing with a flip chip bonder; the solder bumps were fusion-bonded to the board in an IR reflow furnace; and a liquid encapsulating resin (product name: CRP-4152S; manufactured by: Sumitomo Bakelite Co., Ltd.) was filled between the multilayer printed wiring board and semiconductor element and cured, thereby obtaining the semiconductor device. The liquid encapsulating resin was cured under the condition of a temperature of 150°C and a time of 120 minutes.

### <Evaluation of semiconductor device>

In accordance with J-STD-20 of IPC/JEDEC, each of the semiconductor devices obtained above was subjected to a pretreatment under the condition of a temperature of 30°C, a humidity of 60% and a time of 192 hours. Thereafter, it was passed through a reflow furnace at a temperature of 260°C three times, and then subjected to a posttreatment of 500 cycles of -50°C for 30 minutes and 125°C for 30 minutes. Each of the semiconductor devices is evaluated with respect to conduction resistance of the semiconductor element and cross-sectional observation after the pretreatment and after the posttreatment of 500 cycles. The evaluation results are shown in Table 2.
Symbols shown in Table 2 refer to the following:
⊚: There is no problem with conduction resistance after the posttreatment of 500 cycles, and problems with conductor circuit and via hole were not observed by cross-sectional observation
o: There is an increase in conduction resistance in the range of 1 to less than 10% after the posttreatment of 500 cycles; however, problems with conductor circuit and via hole were not observed by cross-sectional observation
×: There is an increase in conduction resistance by 10% or more after the posttreatment of 500 cycles, compared to connection resistance before posttreatment. Or, a microvoid and/or peeling crack was observed between conductor circuit and resin or between via hole and resin.

As is clear from Table 2, the semiconductor devices obtained in Examples II-1 to II-8, had high adhesion and reliability. On the other hand, in Comparative examples II-1 to II-2, there was an increase in conduction resistance; adhesion was poor; and a peeling crack was observed.

### Example series III: Production of resin composition and resin layer

### <Example III-1>

### (1) Production of varnish

The followings were dissolved and dispersed in methyl ethyl ketone: 13.4 parts by weight of a polyfunctional epoxy resin (naphthalene-modified cresol novolac epoxy resin, product name: HP-5000; manufactured by: DIC Corporation), 13.4 parts by weight of a bifunctional epoxy resin (product name: EPIKOTE 828EL; manufactured by: Japan Epoxy Resins Co., Ltd.) and 22.7 parts by weight of a phenol resin (product name: MEH7851-4L; manufactured by: Meiwa Plastic Industries, Ltd.) as thermosetting resins, 8.8 parts by weight (solid content) of a phenoxy resin (product name: YX-8100BH30; manufactured by: Japan Epoxy Resins Co., Ltd.; solid content: 30%) as a thermoplastic resin, 40.8 parts by weight of a spherical silica (product name: NSS-3N; manufactured by: Tokuyama Corporation; average particle diameter: 0.12 µm) containing coarse particles having a diameter of more than 2 µm in an amount of 5 ppm as an inorganic filler, 0.3 part by weight of an imidazole compound (product name: CUREZOL 2E4MZ; manufactured by: Shikoku Chemicals Corporation), and 0.6 part by weight of a silane coupling agent (product name: A-187; manufactured by: Momentive Performance Materials Inc.) A ratio of the inorganic filler in the resin composition was about 41% by weight. The spherical silica used in this example series was obtained by filtering the inorganic filler with a lamination type cartridge filter (manufactured by: Sumitomo 3M Limited) which has a filter having a small pore size of 2 µm, the filler being in a state that coarse particles are preliminarily dispersed in methyl ethyl ketone, to eliminate coarse particles having a maximum particle diameter of more than 2.0 µm, so that the spherical silica has the above-mentioned amount of course particles and average particle diameter. The amount of the coarse particles was confirmed by a particle image analyzer (product name: FPIA-3000S; manufactured by: SYSMEX Corporation).

### (2) Production of resin sheet

The thus-obtained resin varnish was applied onto one surface of a 37 µm thick PET (polyethylene terephthalate) film by means of a comma coater so that the resulting resin film has a thickness of 40 µm when dried, and dried by means of a drying machine at 160°C for 10 minutes, thereby producing a resin sheet.

### (3) Production of evaluation substrate

### (3)-1 Evaluation substrate 1

The above-obtained resin sheet was provided on an inner layer circuit board comprising a glass epoxy substrate and a circuit formed on both surfaces of the substrate and heat-pressed under vacuum at a temperature of 100°C and a pressure of 1 MPa by means of a vacuum press laminator. After removal of the PET substrate, the resultant was heat-cured at 180°C for 45 minutes by means of a hot air drying machine, thereby obtaining a substrate with an insulating layer.
As the inner layer circuit board, the following was used:
Glass epoxy substrate: ELC-4585GS-B (product name; manufactured by: Sumitomo Bakelite Co., Ltd.; thickness: 0.4 mm)
Electroconductive layer: Copper foil (thickness: 18 µm; L/S: 120/180 µm; clearance hole: 1 mmϕ and 3 mmϕ; slit: 2 mm)

By means of excimer laser having a wavelength of 193 nm, grooves having a target width of 10 µm and target depth of 15 µm were formed on the insulating layer. The thus-obtained laminate was immersed in a swelling agent (product name: Swelling Dip Securiganth P500; manufactured by: Atotech Japan K.K.) at 60°C for 10 minutes. In addition, the laminate was immersed in a potassium permanganate aqueous solution (product name: Concentrate Compact CP; manufactured by: Atotech Japan K.K.) at 80°C for 20 minutes, followed by neutralization to perform a desmear treatment.

### (3)-2 Evaluation substrate 2

Next, the surface of the insulating layer of the laminate was subjected to the processes of degreasing, providing a catalyst and activation. Thereafter, an electroless copper plating layer having a thickness of about 0.2 µm was formed thereon. Electrolytic copper plating (product name: Top Lucina α; manufactured by: Okuno Chemical Industries Co., Ltd.) was performed at 3 A/dm² for 30 minutes using the electroless copper plating layer as an electrode, thereby forming a electroconductive layer having a thickness of about 5 µm from the surface of the insulating layer.

### (3)-3 Evaluation substrate 3

By performing a quick etching treatment (product name: SAC process; manufactured by: Ebara Densan Ltd.), the height of the electroconductive layer was made the same as that of the insulating layer surface, and fine wiring processing of L/S= 10/10 was performed. Next, the insulation resin layer was completely cured at 200°C for 60 minutes. At last, the resultant was sandwiched by the same resin layers and heat-pressed under vacuum at a temperature of 100°C and a pressure of 1 MPa by means of a vacuum press laminator, followed by heat-curing at 200°C for 60 minutes by means of a hot air drying machine.

### (3)-4 Semiconductor device

A semiconductor device was produced using the thus-obtained evaluation substrate 3 (printed wiring board).
A semiconductor element (TEG chip, size: 15 mm × 15 mm; thickness: 0.725 mm), solder bumps having a diameter of 120 µm, being formed at a pitch of 150 µm and comprising a Sn/Pb eutectic, and a circuit protection film comprising a positive photosensitive resin (product name: CRC-8300; manufactured by: Sumitomo Bakelite Co., Ltd.) were used. The semiconductor device was produced as follows: a flux material was uniformly applied onto the solder bumps by a transfer method; the semiconductor element was mounted on evaluation substrate 3 by heat pressing with a flip chip bonder; the solder bumps were fusion bonded to the substrate in an IR reflow furnace; and a liquid encapsulating resin (product name: CRP-4152S; manufactured by: Sumitomo Bakelite Co., Ltd.) was filled between evaluation substrate 3 and the semiconductor element and cured, thereby obtaining the semiconductor device. The liquid encapsulating resin was cured under the condition of a temperature of 150°C and a time of 120 minutes.

### <Examples III-2 to III-4>

In each of Examples III-2 to III-4, a resin sheet, evaluation substrates 1, 2 and 3, and a semiconductor device were obtained similarly as in Example III-1, in accordance with the list of Table 3.

### <Example III-5>

### (1) Production of varnish

In accordance with Table 3, a resin varnish was produced similarly as in Example III-1.

### (2) Production of resin sheet

A resin sheet comprising an ultrathin copper foil was produced similarly as in Example III-1, except that an ultrathin copper foil (product name: microthin MT-Ex; manufactured by: Mitsui Mining & Smelting Co., Ltd.; thickness: 3 µm) was used instead of a PET (polyethylene terephthalate) film after producing the resin varnish.

### (3) Production of evaluation substrate

### (3)-1 Evaluation substrate 1

The resin sheet comprising the ultrathin copper foil was provided on an inner layer circuit board comprising a glass epoxy substrate and a circuit formed on both surfaces of the substrate and hot-pressed under vacuum at a temperature of 100°C and a pressure of 1 MPa by means of a vacuum press laminator, followed by heat-curing at 180°C for 45 minutes by means of a hot air drying machine.
Then, the copper foil was removed by etching, thereby obtaining evaluation substrate 1.

### (3)-2 Evaluation substrate 2

Evaluation substrate 2 was obtained using evaluation substrate 1 similarly as in Example III-1.

### (3)-3 Evaluation substrate 3

Evaluation substrate 3 was obtained using evaluation substrate 2 similarly as in Example III-1.

### (3)-4 Semiconductor device

A semiconductor device was obtained using evaluation substrate 3 similarly as in Example III-1.

### <Example III-6>

Evaluation substrates 1, 2 and 3, and a semiconductor device were obtained similarly as in Example III-1, except that grooves having a width of 10 µm and a depth of 15 µm were formed with YAG laser having a wavelength of 355 nm on the insulating layer of the substrate obtained in Example III-4, the insulating layer comprising the resin sheet.

### <Examples III-7 to III-14>

In each of Examples III-7 to III-14, a resin sheet, evaluation substrates 1, 2 and 3, and a semiconductor device were obtained similarly as in Example III-1, in accordance with the list of Table 3.

### <Comparative example III-1>

An evaluation substrate and a semiconductor device were obtained similarly as in Example III-1, except that a general purpose, epoxy resin-based resin sheet (product name: GX-13; manufactured by: Ajinomoto Co., Inc.; maximum particle diameter of inorganic filler: 2.5 µm; average particle diameter of inorganic filler: 0.5 µm) was used. The condition for obtaining evaluation substrate 1 was a temperature of 170°C and a time of 60 minutes, and the condition for obtaining evaluation substrate 3 was a temperature of 180°C and a time of 60 minutes. The amount of coarse particles in the inorganic filler was confirmed by obtaining some resin from the resin sheet, dissolving it in a solvent, and measuring it with a particle image analyzer (product name: FPIA-3000S; manufactured by: SYSMEX Corporation). The amount of the coarse particles having a diameter of more than 2 µm was 8,000 ppm.

### <Comparative example III-2>

In Comparative example III-2, a resin sheet, evaluation substrates 1, 2 and 3, and a semiconductor device were obtained similarly as in Example III-1, in accordance with the list of Table 3.

**[Table 3]**

| | Example III | | | | | | | | | | | | | | Comparative example III |
|---|---|---|---|---|---|---|---|---|---|---|---|---|---|---|---|
| | 1 | 2 | 3 | 4 | 5 | 6 | 7 | 8 | 9 | 10 | 11 | 12 | 13 | 14 | 2 |
| Naphthalene-modified cresol novolac epoxy resin | 13.4 | 13.4 | 13.4 | 32.0 | 32.0 | 32.0 | | | | 43.5 | 39.5 | 19.5 | 21.3 | 32.0 | 13.4 |
| Bis A type epoxy resin | 13.4 | 13.4 | 13.4 | | | | 13.4 | 13.4 | 13.4 | | | | | | 13.4 |
| Anthracene type epoxy resin | | | | | | | 13.4 | | | | | | | | |
| Naphthalene dimethylene type epoxy resin | | | | | | | | 13.4 | | | | | | | |
| Biphenyl dimethylene type epoxy resin | | | | | | | | | 13.4 | | | | | | |
| Biphenyl aralkyl type phenol resin | 22.7 | 22.7 | 22.7 | | | | 22.7 | 22.7 | 22.7 | | | | | | 22.7 |
| Phenol novolac type cyanate resin | | | | 17.5 | 17.5 | 17.5 | | | | 23.9 | 10.0 | 30.0 | 11.7 | 17.5 | |
| Spherical silica: NSS-3N (coarse particles having a diameter of 2 µm: 5 ppm) | 40.8 | | | | | | | | | | | | | | |
| Spherical silica: SFP-20M (coarse particles having a diameter of 2 µm: 250 ppm) | | 40.8 | | 40.9 | 40.9 | 40.9 | 40.8 | 40.8 | 40.8 | 20.0 | 40.9 | 40.9 | 60.0 | | |
| Spherical silica: SFP-30M (coarse particles having a diameter of 2 µm: 480 ppm) | | | 40.8 | | | | | | | | | | | | |
| Boehmite: BMB (coarse particles having a diameter of 2µm: 450 ppm) | | | | | | | | | | | | | | 40.9 | |
| Spherical silica: SC-4050 (coarse particles having a diameter of 2 µm: 3.3%) | | | | | | | | | | | | | | | 40.8 |
| Bis S/Biphenyl type phenoxy resin | 8.8 | 8.8 | 8.8 | 8.9 | 8.9 | 8.9 | 8.8 | 8.8 | 8.8 | 12.0 | 8.9 | 8.9 | 5.9 | 8.9 | 8.8 |
| Silane coupling agent | 0.6 | 0.6 | 0.6 | 0.6 | 0.6 | 0.6 | 0.6 | 0.6 | 0.6 | 0.5 | 0.6 | 0.6 | 0.8 | 0.6 | 0.6 |
| CUREZOL 2E4MZ | 0.3 | 0.3 | 0.3 | | | | 0.3 | 0.3 | 0.3 | | | | | | 0.3 |
| CUREZOL 1B2PZ | | | | 0.1 | 0.1 | 0.1 | | | | 0.2 | 0.1 | 0.1 | 0.3 | 0.1 | |
| Total | 100.0 | 100.0 | 100.0 | 100.0 | 100.0 | 100.0 | 100.0 | 100.0 | 100.0 | 100.0 | 100.0 | 100.0 | 100.0 | 100.0 | 100.0 |
| Laser wavelength upon forming grooves | 193 nm | 193 nm | 193 nm | 193 nm | 193 nm | 355 nm | 193 nm | 193 nm | 193 nm | 193 nm | 193 nm | 193 nm | 193 nm | 193 nm | 193 nm |

Naphthalene-modified cresol novolac epoxy resin: HP-5000 manufactured by DIC Corporation
Bis A type epoxy resin: EPIKOTE 828EL manufactured by Japan Epoxy Resins Co., Ltd.
Anthracene type epoxy resin: EPICLON YX-8800 manufactured by Japan Epoxy Resins Co., Ltd.
Naphthalene dimethylene type epoxy resin: ESN-175 manufactured by Tohto Kasei Co., Ltd.
Biphenyl dimethylene type epoxy resin: NC-3000 manufactured by Nippon Kayaku Co., Ltd.
Biphenyl aralkyl type phenol resin: MEH7851-4L manufactured by Meiwa Plastic Industries, Ltd.
Phenol novolac type cyanate resin: Primaset PT-30 manufactured by Lonza Japan Ltd.
Spherical silica: NSS-3N manufactured by Tokuyama Corporation, 0.12 µm (coarse particles having a diameter of 2 µm: 5 ppm)
Spherical silica: SFP-20M manufactured by Denki Kagaku Kogyo Kabushiki Kaisha, 0.4 µm (coarse particles having a diameter of 2 µm: 250 ppm)
Spherical silica: SFP-30M manufactured by Denki Kagaku Kogyo Kabushiki Kaisha, 0.7 µm (coarse particles having a diameter of 2 µm: 480 ppm)
Boehmite: BMB manufactured by Kawai Lime Industry Co., Ltd., 0.5 µm
Spherical silica: SC-4050 manufactured by Admatechs Company Limited, 1.1 µm (coarse particles having a diameter of 2 µm: 3.3%)
Bis S/Biphenyl type phenoxy resin: YX-8100BH30 manufactured by Japan Epoxy Resins Co., Ltd., solid content: 30%
Silane coupling agent: A-187 manufactured by Momentive Performance Materials Inc.
CUREZOL 2E4MZ manufactured by Shikoku Chemicals Corporation
CUREZOL 1B2PZ manufactured by Shikoku Chemicals Corporation

The resin sheet and evaluation substrates 1, 2 and 3 obtained in each of Examples and Comparative examples were evaluated for the following properties. The results are shown in Table 4.

### (1) Arithmetic average roughness (Ra) of insulating layer surface after desmear

The arithmetic average roughness (Ra) was measured with WYKO NT1100 (product name; manufactured by: Veeco Instruments Inc.) in accordance with JIS B0601. Evaluation substrate 1 was used as the evaluation sample.

### (2) Ten point average roughness (Rz) of side wall surface of electroconductive layer

The ten point average roughness (Rz) was calculated from a cross-section of a conductor wiring in accordance with JIS B0601. Evaluation substrate 2 was used as the evaluation sample.

### (3) Insulation reliability between wirings (HAST)

The insulation reliability between wirings was tested in the condition of an applied voltage of 3.3 VDC, a temperature of 130°C and a humidity of 85%. Evaluation substrate 3 was used as the evaluation sample.
When insulation resistance was less than 1×10⁸ Ω, the evaluation sample was determined as failure and the test was terminated.
Symbols shown in Table 4 refer to the following:
⊚: Good (500 hours or more)
○: Practically no problem (200 hours or more and less than 500 hours)
×: unusable (less than 200 hours)

### (4) Thermal expansion coefficient (α1)

A test piece of 5 mm × 20 mm (thickness: 40 µm) was taken from a sample and measured for linear expansion coefficient in a plane direction (X direction) by means of a TMA device (manufactured by: TA Instruments) in the condition of 5°C/minute and 5 g. An average linear expansion coefficient in the range of 25°C to 120°C was defined as α1. The sample was obtained by laminating a copper foil on both surfaces of the resin sheet obtained above, heat-curing the laminate in the condition of a temperature of 200°C and a time of 1 hour, and removing the copper foil by etching.

### <Evaluation of semiconductor device>

In accordance with J-STD-20 of IPC/JEDEC, the semiconductor device obtained above was subjected to a pretreatment under the condition of a temperature of 30°C, a humidity of 60% and a time of 192 hours. Thereafter, it was passed through a reflow furnace at a temperature of 260°C three times, and then subjected to a posttreatment of 500 cycles of -50°C for 30 minutes and 125°C for 30 minutes. Each of the semiconductor devices is evaluated with respect to conduction resistance of the semiconductor element and cross sectional observation after the pretreatment and after the posttreatment of 500 cycles. Evaluation results are shown in Table 4.
The symbols refer to the following:
⊚: There is no problem with conduction resistance after the posttreatment of 500 cycles, and problems with conductor circuit and via hole were not observed by cross-sectional observation
○: There is an increase in conduction resistance in the range of 1 to less than 10% after the posttreatment of 500 cycles, however, problems with conductor circuit and via hole were not observed by cross-sectional observation
×: There is an increase in conduction resistance by 10% or more after the posttreatment of 500 cycles, compared to connection resistance before posttreatment. Or, a microvoid and/or peeling crack was observed between conductor circuit and resin or between via hole and resin.

**[Table 4]**

| | Example III | | | | | | | | | | | | | | Comparative example III | |
|---|---|---|---|---|---|---|---|---|---|---|---|---|---|---|---|---|
| | 1 | 2 | 3 | 4 | 5 | 6 | 7 | 8 | 9 | 10 | 11 | 12 | 13 | 14 | 1 | 2 |
| (1) Arithmetic average roughness (Ra) of insulating layer surface after desmear (µm) | 0.25 | 0.31 | 0.39 | 0.33 | 0.41 | 0.35 | 0.33 | 0.35 | 0.31 | 0.10 | 0.15 | 0.38 | 0.45 | 0.42 | 0.55 | 0.65 |
| (2) Ten point average roughness (Rz) of side wall surface of electroconductive layer (µm) | 2.8 | 3.8 | 4.8 | 2.0 | 3.9 | 4.9 | 3.0 | 2.9 | 3.9 | 2.1 | 3.0 | 3.5 | 4.5 | 4.6 | 8.7 | 9.2 |
| (3) Insulation reliability between wirings (HAST) (LS10,HAST, 3.3V) | ○ | ○ | ○ | ⊚ | ⊚ | ○ | ⊚ | ⊚ | ⊚ | ⊚ | ⊚ | ⊚ | ○ | ⊚ | × | × |
| (4) Thermal expansion coefficient (α1) | 45 | 45 | 45 | 35 | 35 | 35 | 35 | 37 | 33 | 35 | 38 | 29 | 28 | 38 | 46 | 45 |
| (5) Semiconductor device | ○ | ○ | ○ | ⊚ | ⊚ | ⊚ | ⊚ | ⊚ | ⊚ | ⊚ | ⊚ | ⊚ | ⊚ | ⊚ | × | × |

As is clear from Table 4, in each of Examples III-1 to III-14, the surface of the insulating layer had an arithmetic average roughness (Ra) of 0.05 µm or more and 0.45 µm or less and thus had good low roughness, and the side wall surface of the electroconductive layer had a ten point average roughness (Rz) of 5.0 µm or less. Because the surface roughness was such optimized, fine wirings had excellent insulation reliability. In addition, good fine wirings with excellent signal response could be formed.
In contrast, in each of Comparative examples III-1 and III-2, the inorganic filler had a large particle diameter and the coarse particles were not sufficiently removed, so that the ten point average roughness (Rz) of the side wall surface of the electroconductive layer was large and the distance between conductor wirings was very close. Therefore, fine wirings had poor insulation reliability. Furthermore, the insulating layer had a large Ra, so that Comparative examples III-1 and III-2 are not suitable for forming fine wirings.

### [Industrial Applicability]

A composite body is obtained according to the present invention, comprising a resin layer and a via hole which is formed on the surface of the resin layer of the composite body, has high adhesion and high reliability, is capable of high frequencies, and has excellent plating adhesion inside the via hole and connectivity between layers; therefore, the composite body can be suitably and particularly used for, for example, a printed wiring board comprising a fine wiring having circuit width/circuit distance (L/S) of 10 µm/10 µm or less.

### Reference Signs List

- 1:: Resin layer
- 2:: Electroconductive layer
- 3:: Groove
- 4:: Via hole
- 5:: Laser beam
- 6:: Mask
- 10:: Substrate
- 11:: Electroconductive layer of core substrate with electroconductive layers on both surfaces thereof
- 15:: Substrate
- 20:: Resin layer
- 30:: Resin sheet for wiring board
- 40:: Different resin layer
- 50:: Electroless plating layer
- 51:: Electroless plating layer
- 52:: Electroless plating layer
- 60:: Electrolytic plating layer
- 61:: Electrolytic plating layer
- 62:: Electrolytic plating layer
- 70:: Electric conductor
- 100:: First composite body
- 101:: Second composite body
- 102:: Second composite body

## Claims

1. A composite body comprising a resin layer and an electroconductive layer,
wherein a groove having a maximum width of 1 µm or more and 10 µm or less is on a surface of the resin layer; the electroconductive layer is inside the groove; and a surface of the resin layer being in contact with the electroconductive layer has an arithmetic average roughness (Ra) of 0.05 µm or more and 0.45 µm or less.

2. A composite body comprising a resin layer and an electroconductive layer,
wherein the resin layer has a via hole having a diameter of 1 µm or more and 25 µm or less; the electroconductive layer is inside the via hole; and a surface of the resin layer of the inside of the via hole has an arithmetic average roughness (Ra) of 0.05 µm or more and 0.45 µm or less.

3. The composite body according to Claim 2, wherein a groove having a maximum width of 1 µm or more and 10 µm or less is further on the surface of the resin layer; the electroconductive layer is further inside the groove; and a surface of the resin layer being in contact with the electroconductive layer has an arithmetic average roughness (Ra) of 0.05 µm or more and 0.45 µm or less.

4. The composite body according to any of Claims 1 to 3, wherein the resin layer comprises an inorganic filler, and the inorganic filler contains coarse particles having a diameter of more than 2 µm in an amount of 500 ppm or less.

5. The composite body according to Claim 4, wherein the inorganic filler has an average particle diameter of 0.05 µm or more and 1.0 µm or less.

6. The composite body according to any of Claims 1 to 5, wherein a cross-sectional shape of the electroconductive layer inside the groove is an approximate trapezoidal shape, a semicircular shape or a triangular shape.

7. The composite body according to any of Claims 2 to 6, wherein a cross-sectional shape of the via hole is an approximate trapezoidal shape.

8. The composite body according to any of Claims 1 to 7, wherein the composite body is at least one selected from a printed wiring board, a semiconductor element and a metal core wiring board.

9. A method for producing a composite body comprising a resin layer and an electroconductive layer, comprising:
(A) a step of forming a groove having an inner surface with an arithmetic average roughness (Ra) of 0.05 µm or more and 0.45 µm or less on a surface of the resin layer with laser beam,
(B) a step of forming an electric conductor on the surface of the resin layer by electroless plating, and
(C) a step of forming an electroconductive layer only in the groove on the resin layer by removing part of the electric conductor.

10. The method for producing the composite body according to Claim 9, wherein the method comprises, after the step (C), (D) a step of forming a different resin layer on the resin layer and the electroconductive layer.

11. A method for producing a composite body comprising a resin layer and an electroconductive layer, comprising:
(A) a step of forming a via hole having an inner surface with an arithmetic average roughness (Ra) of 0.05 µm or more and 0.45 µm or less in the resin layer with laser beam,
(B) a step of forming an electric conductor on a surface of the resin layer by electroless plating, and
(C) a step of forming an electroconductive layer only in the via hole of the resin layer by removing part of the electric conductor.

12. The method for producing the composite body according to Claim 11,
wherein the step (A) is a step of forming the via hole having the inner surface with an arithmetic average roughness (Ra) of 0.05 µm or more and 0.45 µm or less in the resin layer with laser beam, and a groove having an inner surface with an arithmetic average roughness (Ra) of 0.05 µm or more and 0.45 µm or less on a surface of the resin layer with laser beam, and
the step (C) is a step of forming the electroconductive layer only in the via hole of the resin layer and the groove on the surface of the resin layer by removing part of the electric conductor.

13. The method for producing the composite body according to Claim 11 or 12, wherein the method comprises, after the step (C), (D) a step of forming a different resin layer on the resin layer and the electroconductive layer.

14. The method for producing the composite body according to any of Claims 9 to 13, wherein the method comprises a step of performing desmear with plasma or chemical solution between the steps (A) and (B).

15. The method for producing the composite body according to any of Claims 9 to 14, wherein the method comprises a step of further forming an electric conductor by electrolytic plating between the steps (B) and (C).

16. The method for producing the composite body according to any of Claims 9 to 15, wherein the laser beam is excimer laser or YAG laser.

17. The method for producing the composite body according to any of Claims 9 to 16, wherein, in the step (A), the resin layer comprises an inorganic filler, and the inorganic filler contains coarse particles having a diameter of more than 2 µm in an amount of 500 ppm or less.

18. The method for producing the composite body according to Claim 17, wherein the inorganic filler has an average particle diameter of 0.05 µm or more and 1.0 µm or less.

19. The method for producing the composite body according to any of Claims 9 to 18, wherein the composite body is at least one selected from a printed wiring board, a semiconductor element and a metal core wiring board.

20. A semiconductor device comprising the composite body defined by any of Claims 1 to 8 and a semiconductor element mounted thereon, wherein the composite body is a printed wiring board or metal core wiring board.

21. A resin composition for wiring board, comprising an inorganic filler and a thermosetting resin, wherein the inorganic filler contains coarse particles having a diameter of more than 2 µm in an amount of 500 ppm or less.

22. The resin composition for wiring board according to Claim 21, wherein the inorganic filler has an average particle diameter of 0.05 µm or more and 1.0 µm or less.

23. The resin composition for wiring board according to Claim 21 or 22, wherein a content of the inorganic filler is 10 to 80% by weight of the resin composition.

24. The resin composition for wiring board according to any of Claims 21 to 23, wherein the inorganic filler is spherical silica.

25. A resin sheet for wiring board, comprising a resin layer and a substrate, wherein the resin layer is on the substrate and comprises the resin composition defined by any of Claims 21 to 24.
